(19) Europäisches Patentamt
European Patent Office
Office européen des brevets

(11) **EP 4 205 283 B1**

(12) **EUROPEAN PATENT SPECIFICATION**

(45) Date of publication and mention
of the grant of the patent:
**05.08.2026   Bulletin 2026/32**

(21) Application number: **20830100.2**

(22) Date of filing: **11.12.2020**

(51) International Patent Classification (IPC):
*H03M 13/13* (2006.01)       *H03M 13/29* (2006.01)
*H03M 13/00* (2006.01)

(52) Cooperative Patent Classification (CPC):
**H03M 13/13; H03M 13/2909; H03M 13/6362;
H03M 13/618**

(86) International application number:
**PCT/EP2020/085672**

(87) International publication number:
**WO 2022/122166 (16.06.2022 Gazette 2022/24)**

(54) **RATE MATCHING FOR POLAR PRODUCT CODES**

RATENANPASSUNG FÜR POLAR PRODUKT-KODES

ADAPTATION DU TAUX DU CODE POUR LES CODES DE PRODUIT POLAIRES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**05.07.2023   Bulletin 2023/27**

(73) Proprietor: **Huawei Technologies Co., Ltd.
Shenzhen, Guangdong 518129 (CN)**

(72) Inventors:
• **LAND, Ingmar**
  **80992 Munich (DE)**
• **CONDO, Carlo**
  **80992 Munich (DE)**
• **PILLET, Charles**
  **80992 Munich (DE)**
• **BIOGLIO, Valerio**
  **80992 Munich (DE)**

(74) Representative: **Roth, Sebastian
Mitscherlich PartmbB
Karlstraße 7
80333 München (DE)**

(56) References cited:
**EP-A1- 1 317 070**

• **ABU HANIF MOHAMMAD ET AL: "A Modified
Approach to Punctured Product Polar Codes",
JOURNAL OF TELECOMMUNICATIONS AND
INFORMATION TECHNOLOGY, vol. 3, no. 2019,
30 September 2019 (2019-09-30), pages 63 - 69,
XP093282625, ISSN: 1509-4553, DOI: 10.26636/
jtit.2019.132219**
• **ALI ESLAMI ET AL: "A Practical Approach to
Polar Codes", ARXIV.ORG, CORNELL
UNIVERSITY LIBRARY, 201 OLIN LIBRARY
CORNELL UNIVERSITY ITHACA, NY 14853, 27
July 2011 (2011-07-27), XP080517802, DOI:
10.1109/ISIT.2011.6033837**
• **SARKIS GABI ET AL: "Flexible and Low-
Complexity Encoding and Decoding of
Systematic Polar Codes", IEEE TRANSACTIONS
ON COMMUNICATIONS, IEEE SERVICE CENTER,
PISCATAWAY, NJ. USA, vol. 64, no. 7, 1 July 2016
(2016-07-01), pages 2732 - 2745, XP011616638,
ISSN: 0090-6778, [retrieved on 20160713], DOI:
10.1109/TCOMM.2016.2574996**

- HANIF MOHAMMAD ABU ET AL: "A Novel Scheme of Product Polar Codes with High Efficiency and Rate Compatibility", WIRELESS COMMUNICATIONS AND MOBILE COMPUTING, vol. 2020, 13 April 2020 (2020-04-13), pages 1 - 13, XP055829589, ISSN: 1530-8669, Retrieved from the Internet <URL:https://downloads.hindawi.com/journals/wcmc/2020/7573147.pdf> [retrieved on 20210803], DOI: 10.1155/2020/7573147
- KOIKE-AKINO TOSHIAKI ET AL: "EXIT Convergence Analysis of BICM-ID Based on High-Dimensional Modulation and Polar-TPC", PROC. IEEE EUROPEAN CONFERENCE ON OPTICAL COMMUNICATION (ECOC) 2018, IEEE, 23 September 2018 (2018-09-23), pages 1 - 3, XP033447780, DOI: 10.1109/ECOC.2018.8535499
- CONDO CARLO ET AL: "Practical Product Code Construction of Polar Codes", IEEE TRANSACTIONS ON SIGNAL PROCESSING, IEEE SERVICE CENTER, NEW YORK, NY, US, vol. 68, 18 March 2020 (2020-03-18), pages 2004 - 2014, XP011782656, ISSN: 1053-587X, [retrieved on 20200408], DOI: 10.1109/TSP.2020.2981766
- BIOGLIO VALERIO ET AL: "Construction and Decoding of Product Codes with Non-Systematic Polar Codes", PROC. IEEE WIRELESS COMMUNICATIONS AND NETWORKING CONFERENCE (WCNC) 2019, IEEE, 15 April 2019 (2019-04-15), pages 1 - 6, XP033652357, DOI: 10.1109/WCNC.2019.8886100
- RUAN MENG ET AL: "Near Optimal Decoding of Polar-based Turbo Product Codes", PROC. 11TH INTERNATIONAL CONFERENCE ON WIRELESS COMMUNICATIONS AND SIGNAL PROCESSING (WCSP) 2019, IEEE, 23 October 2019 (2019-10-23), pages 1 - 5, XP033671615, DOI: 10.1109/WCSP.2019.8927852
- VALERIO BIOGLIO ET AL: "Low-Complexity Puncturing and Shortening of Polar Codes", ARXIV.ORG, CORNELL UNIVERSITY LIBRARY, 201 OLIN LIBRARY CORNELL UNIVERSITY ITHACA, NY 14853, 23 January 2017 (2017-01-23), XP080750896, DOI: 10.1109/WCNCW.2017.7919040
- TONNELLIER THIBAUD ET AL: "Length-Compatible Polar Codes: A Survey : (Invited Paper)", PROC. 53RD ANNUAL CONFERENCE ON INFORMATION SCIENCES AND SYSTEMS (CISS) 2019, IEEE, 20 March 2019 (2019-03-20), pages 1 - 6, XP033539158, DOI: 10.1109/CISS.2019.8692789
- "V0.d-4th-Draft (2001-12) Broadband Radio Access Networks (BRAN); HIPERACCESS Functional Specification Part 1 Physical (PHY) Layer, 4th DRAFT", vol. 802.11 ETSI BRAN, no. V0, 12 September 2002 (2002-09-12), pages 1 - 81, XP068142113, Retrieved from the Internet <URL:www.ieee802.org/11/private/ETSI_documents/BRAN.bak/Docfile/BRAN18-28/BRAN26/Ha_PHY_TS_V0_d-fourth-draft-r1.doc> [retrieved on 20020912]

## Description

TECHNICAL FIELD

The present disclosure relates to the field of channel coding using polar codes, in particular, using product polar codes. The disclosure presents, accordingly, a device for product polar-code encoding, a device for product polar-code decoding, and corresponding methods. In particular, embodiments of this disclosure implement product polar-code encoding and decoding, which enable puncturing and/or shortening to implement rate matching of product polar codes.

BACKGROUND

Digital communication systems are prone to transmission errors. To counteract such errors, channel coding and, in particular, forward error correction (FEC) coding are used. A coding scheme usually consists of an encoder at the transmitter side and a decoder at the receiver side. The encoder adds redundancy to the data to be transmitted, and the decoder exploits this redundancy to correct transmission errors when decoding the data. This disclosure is particularly concerned with such coding schemes.

Polar codes, as introduced by Arikan, are a particular class of channel codes. The polar codes rely on the so-called polarization effect of the polarization transform, and they are asymptotically optimal, i.e., they attain the channel capacity when the code length goes to infinity. Polar codes can be defined for code lengths that are powers of 2, and these polar codes are based on the kernel matrix

$$T_2 = \begin{bmatrix} 1 & 0 \\ 1 & 1 \end{bmatrix}$$

For a polar code of code length $N = 2^n$, an information length $K$, and a code rate $R = K/N$, the index set $\{1, 2, ..., N\}$ is partitioned into two subsets, namely the information set of bits $I$ of size $K$, and the frozen set of bits $F$ of size $N - K$. The choice of these two sets of bits is part of the polar code design.

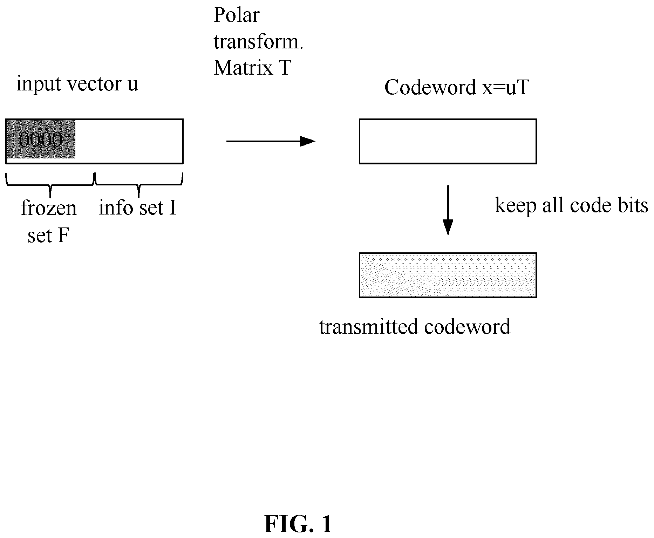

Conventional polar-code encoding is illustrated in FIG. 1. An input vector $u$ is formed by setting the bits $u_i$ to 0 for $i \in F$ (i.e., for the bits in the frozen set of bits) and setting them to the information bits for $i \in I$, wherein i is a natural number. The codeword is computed as $x = uT$ with the transformation matrix $T = T_2^{\otimes n}$, denoting the n-fold Kronecker product.

Polar-code decoding is typically based on successive cancellation (SC) decoding. Thereby, the decoder starts with a decision for bit $u_1$, and feeds this decision back into the decoding process. Then it makes a decision of bit $u_2$ and feeds this decision back into the decoding process. It then proceeds in this fashion, until it obtains the decision for the last bit $u_N$. Besides SC-based decoding algorithms, e.g. SC list decoding, also belief propagation (BP)-based decoding algorithms may be applied, e.g. Soft Cancellation (SCAN) or SCAN-list decoding.

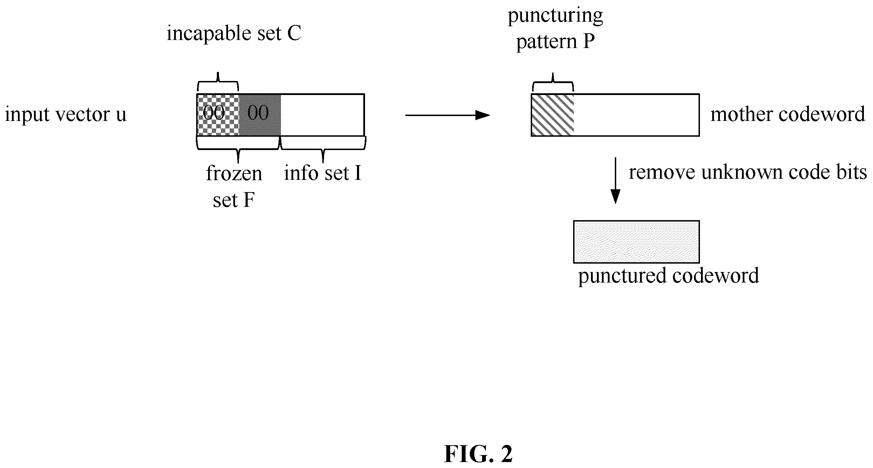

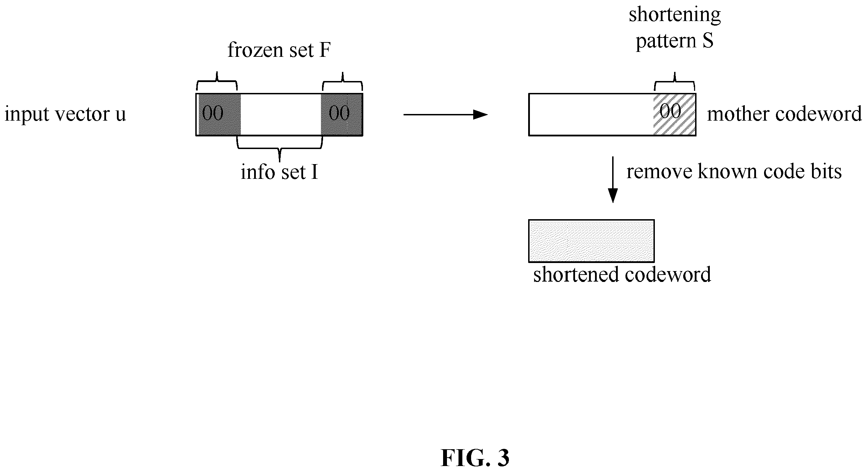

Many practical applications require a large set of codes with codes having different code lengths. For an efficient implementation, only a small set of codes - termed "mother codes" - may be defined, and other codes of shorter lengths and different code rates may be derived by using puncturing or by using shortening. This is usually termed "rate-matching". In the case of polar codes, the mother polar codes are those having lengths that are powers of two, and codes of other lengths are constructed via puncturing or shortening. For polar codes, these techniques work as shown in FIG. 2 for puncturing, and as shown in FIG. 3 for shortening. Thereby, it is assumed that a mother polar code of length $N = 2^n$ is given.

For puncturing (see FIG. 2), the bits of the input vector u are frozen according to the frozen set $F$. Then, the mother codeword is obtained by applying the polar transform, $x = uT$. The punctured codeword $x_p$ is then formed by deleting positions specified by a puncturing pattern $P$, i.e., the code bits $x_i$ are removed for $i \in P$. Note that the removed code bits have arbitrary values that are unknown at the receiver. The punctured codeword $x_p$ is then transmitted. At the receiver side, log-likelihood ratios (LLRs) are computed for the transmitted bits, and an LLR of zero is assumed for the punctured bits with $i \in P$. Then decoding is performed for the mother codeword. Note that certain conditions between the frozen set of bits $F$ and the puncturing pattern $P$ need to be considered, in order to avoid the so-called catastrophic error behaviour. The puncturing pattern $P$ induces an incapable set of bits $C$ to the input vector, and the encoder must assure that $C \subseteq F$.

For shortening (see FIG. 3), the bits of the input vector $u$ are frozen according to the frozen set of bits $F$, which has a specific relationship to a shortening pattern $S$. The mother codeword is then obtained by applying the polar transform, $x = uT$. The shortened codeword $x_s$ is then formed by deleting positions specified by a shortening pattern $S$, i.e., code bits $x_i$ are removed for $i \in S$. Notably, the removed code bits are all zero, due to the particular choice of $F$ and $S$, thus their values are known at the receiver. The shortened codeword $x_s$ is then transmitted. At the receiver side, LLRs are computed for the transmitted bits, and an LLR of positive infinity (or in practice a large positive value) is assumed for the shortened bits for $i \in S$. Then decoding is performed for the mother codeword. Note that certain conditions between the frozen set of bits $F$ and the shortening pattern $S$ need to be considered.

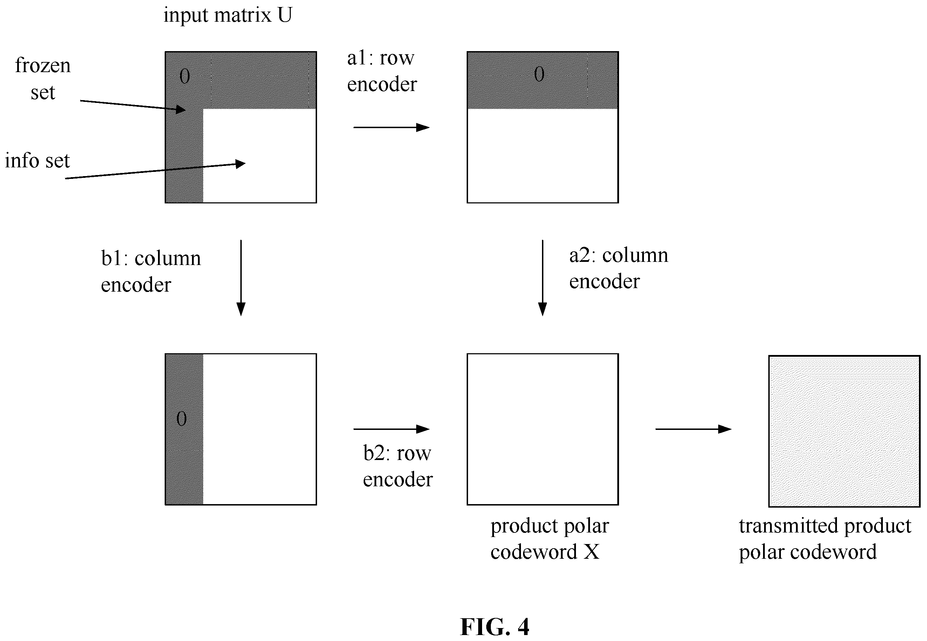

Product codes are a class of error-correction codes, which are constructed by encoding a matrix of information symbols row-wise using row component codes, and subsequently column-wise using column component codes. Product codes may be formed using polar codes as the component codes. Considering the case where the row and column component polar codes have lengths $N_r$ and $N_c$, respectively, encoding is performed as shown in FIG. 4. A frozen set of bits is specified for each row and for each column. An input matrix $U$ of size $N_c \times N_r$ is then filled such that in every row and every column there is a zero at the positions indicated by the frozen set of bits, and the remaining positions are filled with the information bits. Then row-encoding by a row-encoder is performed. Thereby, each of the $N_c$ rows is multiplied by the transformation matrix, and the resulting new rows are written into a new $N_c \times N_r$ matrix. Afterwards, column-encoding is performed by a column-encoder on the new matrix, wherein each of the $N_r$ column is multiplied by the transformation matrix, and the resulting new columns are written into a matrix. This $N_c \times N_r$ matrix is referred to as the codeword (or codeword matrix $X$) of the product code. Note that, alternatively, first column-encoding and then row-encoding may be performed, which leads to the same result because of the linearity of the codes.

For decoding, iterative product code decoding is usually applied, though generalisations are possible. In an initialization step, LLRs (or equivalent soft values) are computed for all code bits based on the observations from the channel. In the row-decoding step, each of the $N$ rows is decoded independently (which may be done in parallel). In the column-decoding step, each of the $N$ columns is decoded independently (which again may be done in parallel). Then row-decoding and column-decoding are iterated, and the decoders exchange soft or hard information in a turbo fashion, until a certain number of iterations is reached, or until a termination criterion is fulfilled. The frozen bits available for row-decoding are as indicated in FIG. 4 in the lower left part (after the column-encoding), and the frozen bits available for column-decoding are as indicated in FIG. 4 in the upper right part (after the row-encoding). Note that these frozen bits available for the row-decoding and column-decoding may be fewer than the bits in the frozen set of bits specified for encoding in the input matrix, as shown in FIG. 4 in the upper left part, depending on the mutual structure of the frozen bits. In general, it is preferable for good error-correction performance that the frozen bits for component code decoding are as many as possible, and thus are as close as possible to the number initially defined.

Given the principle of their construction, product polar codes have a code length of $N = N_c \times N_r$, wherein $N_c$ and $N_r$ are powers of 2 when Arikan polar codes are used as the component codes. For many applications, a much wider range of code lengths is required. The code rate, on the contrary, can be chosen almost freely, and only mild constraints need to be considered.

HANIF MOHAMMAD ABU ET AL: "A Novel Scheme of Product Polar Codes with High Efficiency and Rate Compatibility", WIRELESS COMMUNICATIONS AND MOBILE COMPUTING, vol. 2020, pages 1-13, discloses a product coding scheme of polar codes formed by two different rates of polar codes, where punctured product polar codes can be constructed by removing a low number of bits applied in one of the constituent codes.

KOIKE-AKINO TOSHIAKI ET AL: "EXIT Convergence Analysis of BICM-ID Based on High-Dimensional Modulation and Polar-TPC", PROC. IEEE EUROPEAN CONFERENCE ON OPTICAL COMMUNICATION (ECOC) 2018, IEEE, pages 1-3, discloses polar turbo product codes (TPC), using multiple polar constituent codes, in the context of bit-interleaved coded modulation and used with high-dimensional modulations.

CONDO, CARLO ET AL: "Practical Product Code Construction of Polar Codes", IEEE TRANSACTIONS ON SIGNAL PROCESSING, IEEE SERVICE CENTER, NEW YORK, NY, US, vol. 68, pages 2004-2014, discloses the connection between polar codes and product codes, and a manner to compute its frozen set on the basis of the frozen sets of the component polar codes. A two-step decoder for long polar codes to heavily reduce decoding latency is also disclosed.

BIOGLIO VALERIO ET AL: "Construction and Decoding of Product Codes with Non-Systematic Polar Codes", PROC. IEEE WIRELESS COMMUNICATIONS AND NETWORKING CONFERENCE (WCNC) 2019, IEEE, pages 1-6, discloses a construction for product polar codes based on non-systematic polar codes. The resulting product code is actually a polar code, having a frozen set that is dependent on the frozen sets of the component polar codes. A low-complexity decoding algorithm exploiting the dual nature of the constructed code is considered.

RUAN MENG ET AL: "Near Optimal Decoding of Polar-based Turbo Product Codes", PROC. 11TH INTERNATIONAL CONFERENCE ON WIRELESS COMMUNICATIONS AND SIGNAL PROCESSING (WCSP) 2019, IEEE, pages 1-5, discloses a decoding algorithm for the TPC code with systematic and non-systematic constituent codes, and a flipping-based successive cancellation list (SCL) decoder.

TONNELLIER THIBAUD ET AL: "Length-Compatible Polar Codes: A Survey": (Invited Paper)", PROC. 53RD ANNUAL CONFERENCE ON INFORMATION SCIENCES AND SYSTEMS (CISS) 2019, IEEE, pages 1-6, discloses that rate-matching techniques, known as puncturing and shortening, have been applied to polar codes to grant a flexible block length, and that multi-kernel polar codes improve natural block length flexibility by considering polarizing kernels of alternate dimensions.

Abu Hanif Mohammad ET AL: "A Modified Approach to Punctured Product Polar Codes", J. of Telecommunications and Information Technology, vol. 3, no. 2019, pages 63-69, discloses a puncturing algorithm for product codes constructed by two identical polar codes. Puncturing is conducted on both constituent codes, to ensure that the new code outperforms the previously punctured product polar and single polar codes.

ALI ESLAMI ET AL: "A Practical Approach to Polar Codes", arXiv:1107.5355v1, discloses concatenated polar codes and rate-compatible polar codes, and the effect of puncturing on polar codes to design rate-compatible codes.

SARKIS GABI ET AL: "Flexible and Low-Complexity Encoding and Decoding of Systematic Polar Codes", IEEE TRANSACTIONS ON COMMUNICATIONS, IEEE SERVICE

CENTER, USA, vol. 64, no. 7, pages 2732-2745 discloses hardware and software implementations of flexible polar systematic encoders and decoders that operate on polar codes of any length less than a maximum and of any rate.

EP 1 317 070 A1 discloses a method for obtaining from a block turbo-code an error correcting code of desired parameters, as well as a a method for decoding such an error correcting code.

## SUMMARY

Embodiments of the invention are based further on the following considerations.

It would generally be desirable to give more flexibility to product polar codes, and to make them suitable for a wider range of applications. In particular, it would be beneficial to allow a joint adaptation of the length and rate of product polar codes. Such an adaption is usually referred to as "rate-matching" in digital communications.

However, simply applying standard techniques, like puncturing or shortening, without taking the structure of the product polar codes into account, leads to poor error-rate performance. In particular, conventional rate-matching techniques, based on puncturing or shortening, are well studied for product codes, but these techniques do not directly apply to product polar codes, since they are not systematic. Similarly, standard puncturing and shortening for channel codes could be applied to product polar codes blindly, without considering specific requirements for product polar codes. However, these techniques do not lead to an acceptable block error rate (BLER) performance.

The present disclosure aims to overcome the above-mentioned challenges and disadvantages. An objective is, in particular, to provide a rate-matching technique that is specific to product polar codes. Thereby, the excellent performance of the product polar codes should be maintained, while their length and rate are adapted. Another objective is to provide devices for product polar-code encoding (encoding device) and for product polar-code decoding (decoding device), which enable puncturing and/or shortening.

These and other objectives are achieved by the embodiments of the invention as described in the appended claims. Advantageous implementations of the embodiments of the invention are further defined in the dependent claims. In the following, parts of the description and drawings referring to embodiments which are not covered by the claims are not presented as embodiments of the invention, but as examples useful for understanding the invention.

In particular, embodiments of the invention are based on adapting the length and the rate of product polar codes. For instance, starting from a mother product polar code of length $N = N_c \times N_r$, wherein both $N_c$ and $N_r$ are powers of 2, embodiments of the invention allow reducing the code length to any desired length $N'$, by jointly considering the choice of the frozen set of bits, while maintaining good error-rate performance. The embodiments are based on carefully combining the frozen bits of component polar codes in specific ways, in order to achieve desired properties of the product polar code, such that its length can be reduced using puncturing and/or shortening.

A first aspect of this disclosure provides a device for product polar-code encoding, the device being configured to: obtain an input matrix comprising a frozen set of bits and an information set of bits; polar-encode the input matrix to obtain a first codeword matrix; determine an exclusion set of bits in the first codeword matrix; and transmit a second codeword matrix, wherein the second codeword matrix is obtained by removing the exclusion set of bits from the first codeword matrix.

By removing the exclusion set of bits, the first codeword matrix is reduced in size, e.g., is punctured or shortened, to obtain the second codeword matrix. Thus, the device of the first aspect enables a rate-matching that is specific to a product polar code. Thereby, the excellent performance of the product polar code can be maintained, while its length and rate are adapted.

In an implementation form of the first aspect, the second codeword matrix is a punctured codeword matrix obtained by puncturing the first codeword matrix based on the exclusion set of bits, or the second codeword matrix is a shortened codeword matrix obtained by shortening the first codeword matrix based on the exclusion set of bits, or the second codeword matrix is a punctured-and-shortened codeword matrix obtained by puncturing and shortening the first codeword matrix based on the exclusion set of bits.

Accordingly, at least one of puncturing and shortening may be applied to obtain the second codeword matrix, in order to enable the rate matching.

In an implementation form of the first aspect, the device is configured to generate the second codeword matrix by puncturing and/or shortening the first codeword matrix based on the exclusion set of bits.

In particular, the second codeword matrix may be punctured by removing the exclusion set of bits, or may be shortened by removing the exclusion set of bits.

In an implementation form of the first aspect, the device is configured to determine the exclusion set of bits in the first codeword matrix according to a predetermined puncturing and/or shortening pattern; wherein the puncturing and/or shortening pattern is related to the frozen set of bits in the input matrix.

The puncturing pattern and/or the shortening pattern may be determined by the device of the first aspect based on the frozen set of bits, or vice versa.

In an implementation form of the first aspect, the device is configured to generate the input matrix, wherein the frozen set of bits in the input matrix is based on the predetermined puncturing and/or shortening pattern.

In an implementation form of the first aspect, the frozen set of bits in the input matrix comprises a sub-set of bits; and the exclusion set of bits in the first codeword matrix is determined based on the sub-set of bits of the frozen set of bits in the input matrix.

The sub-set of bits is also referred to as a set of incapable bits in this disclosure.

In an implementation form of the first aspect, the device is configured to polar-encode one or more columns of the input matrix to obtain a first matrix, and polar-encode one or more rows of the first matrix to obtain the first codeword matrix; or polar-encode one or more rows of the input matrix to obtain a second matrix, and polar-encode one or more columns of the second matrix to obtain the first codeword matrix.

In an implementation form of the first aspect, the device is configured to polar-encode the one or more columns of the input matrix, or the one or more columns of the second matrix, based on a first component code; and polar-encode the one or more rows of the first matrix, or the one or more rows of the input matrix, based on a second component code; wherein one component code of the first component code and the second component code is a punctured and/or shortened component code, which comprises less bits than the other component code.

In an implementation form of the first aspect, the device is configured to determine the exclusion set of bits according to an edge-puncturing pattern, wherein the exclusion set of bits is selected from one or more columns and one or more rows of the first codeword matrix, the columns and rows being arranged adjacently at two adjoining edges of the first codeword matrix.

Thus, the second codeword matrix may be obtained by edge-puncturing the first codeword matrix based on the exclusion set of bits.

In an implementation form of the first aspect, the device is configured to determine the exclusion set of bits according to a corner-puncturing pattern, wherein the exclusion set of bits is selected from a corner area arranged between two adjoining edges of the first codeword matrix.

Thus, the second codeword matrix may be obtained by corner-puncturing the first codeword matrix based on the exclusion set of bits.

In an implementation form of the first aspect, the device is configured to determine the exclusion set of bits according to a one-dimensional puncturing pattern, wherein the exclusion set of bits is selected from one or more columns arranged at an edge of the first codeword matrix.

Thus, the second codeword matrix may be obtained by 1D-puncturing the first codeword matrix based on the exclusion set of bits.

In an implementation form of the first aspect, the device is configured to determine the exclusion set of bits according to an edge-shortening pattern, wherein the exclusion set of bits is selected from a number of one or more columns and from the same number of one or more rows of the first codeword matrix, the columns and rows being arranged adjacently at two adjoining edges of the first codeword matrix.

Thus, the second codeword matrix may be obtained by edge-shortening the first codeword matrix based on the exclusion set of bits.

In an implementation form of the first aspect, the device is configured to determine the exclusion set of bits according to a corner-shortening pattern, wherein the exclusion set of bits is selected from a square of entries arranged in a corner area between two adjoining edges of the first codeword matrix.

Thus, the second codeword matrix may be obtained by corner-shortening the first codeword matrix based on the exclusion set of bits.

In an implementation form of the first aspect, the device is configured to determine the exclusion set of bits according to a one-dimensional shortening pattern, wherein the exclusion set of bits is selected from one or more columns arranged at an edge of the first codeword matrix.

Thus, the second codeword matrix may be obtained by 1D-shortening the first codeword matrix based on the exclusion set of bits.

In an implementation form of the first aspect, the device is configured to determine a second frozen set of bits in the input matrix, wherein the frozen set of bits and the second frozen set of bits do not overlap; and determine the exclusion set of bits in the first codeword matrix according to the position of the second frozen set of bits in the input matrix.

This may further improve the performance of the product polar-code encoding including the puncturing and/or shortening.

In an implementation form of the first aspect, the second frozen set of bits is arranged in at least one of a row and a column, which are respectively arranged adjacent to the frozen set of bits in the input matrix; or the second frozen set of bits is arranged in at least one of a row and a column, which are arranged at respective edges of the input matrix.

A second aspect of this disclosure provides a device for product polar-code decoding, the device being configured to: receive a second codeword matrix; and determine a first codeword matrix based on the second codeword matrix, wherein the first codeword matrix is obtained by adding a determined set of bits or a determined set of reals values to the second codeword matrix; and polar-decode the first codeword matrix to obtain an input matrix.

The device of the second aspect supports the rate-matching enabled by the device of the first aspect. In particular, it may add the determined set of bits or real values based on the exclusion set of bits removed by the device of the first aspect.

A third aspect of this disclosure provides a method for product polar-code encoding, the method comprising: obtaining an input matrix comprising a frozen set of bits and an information set of bits; polar-encoding the input matrix to obtain a first codeword matrix; determining an exclusion set of bits in the first codeword matrix; and transmitting a second codeword matrix, wherein the second codeword matrix is obtained by removing the exclusion set of bits from the first codeword matrix.

In an implementation form of the third aspect, the second codeword matrix is a punctured codeword matrix obtained by puncturing the first codeword matrix based on the exclusion set of bits, or the second codeword matrix is a shortened codeword matrix obtained by shortening the first codeword matrix based on the exclusion set of bits, or the second codeword matrix is a punctured-and-shortened codeword matrix obtained by puncturing and shortening the first codeword matrix based on the exclusion set of bits.

In an implementation form of the third aspect, the method comprises: generating the second codeword matrix by puncturing and/or shortening the first codeword matrix based on the exclusion set of bits.

In an implementation form of the third aspect, the method comprises determining the exclusion set of bits in the first codeword matrix according to a predetermined puncturing and/or shortening pattern; wherein the puncturing and/or shortening pattern is related to the frozen set of bits in the input matrix.

In an implementation form of the third aspect, the method comprises generating the input matrix, wherein the frozen set of bits in the input matrix is based on the predetermined puncturing and/or shortening pattern.

In an implementation form of the third aspect, the frozen set of bits in the input matrix comprises a sub-set of bits; and the exclusion set of bits in the first codeword matrix is determined based on the sub-set of bits of the frozen set of bits in the input matrix.

In an implementation form of the third aspect, the method comprises polar-encoding one or more columns of the input matrix to obtain a first matrix, and polar-encoding one or more rows of the first matrix to obtain the first codeword matrix; or polar-encoding one or more rows of the input matrix to obtain a second matrix, and polar-encoding one or more columns of the second matrix to obtain the first codeword matrix.

In an implementation form of the third aspect, the method comprises polar-encoding the one or more columns of the input matrix, or the one or more columns of the second matrix, based on a first component code; and polar-encoding the one or more rows of the first matrix, or the one or more rows of the input matrix, based on a second component code; wherein one component code of the first component code and the second component code is a punctured and/or shortened component code, which comprises less bits than the other component code.

In an implementation form of the third aspect, the method comprises determining the exclusion set of bits according to an edge-puncturing pattern, wherein the exclusion set of bits is selected from one or more columns and one or more rows of the first codeword matrix, the columns and rows being arranged adjacently at two adjoining edges of the first codeword matrix.

In an implementation form of the third aspect, the method comprises determining the exclusion set of bits according to a corner-puncturing pattern, wherein the exclusion set of bits is selected from a corner area arranged between two adjoining edges of the first codeword matrix.

In an implementation form of the third aspect, the method comprises determining the exclusion set of bits according to a one-dimensional puncturing pattern, wherein the exclusion set of bits is selected from one or more columns arranged at an edge of the first codeword matrix.

In an implementation form of the third aspect, the method comprises determining the exclusion set of bits according to an edge-shortening pattern, wherein the exclusion set of bits is selected from a number of one or more columns and from the same number of one or more rows of the first codeword matrix, the columns and rows being arranged adjacently at two adjoining edges of the first codeword matrix.

In an implementation form of the third aspect, the method comprises determining the exclusion set of bits according to a corner-shortening pattern, wherein the exclusion set of bits is selected from a square of entries arranged in a corner area between two adjoining edges of the first codeword matrix.

In an implementation form of the third aspect, the method comprises determining the exclusion set of bits according to a one-dimensional shortening pattern, wherein the exclusion set of bits is selected from one or more columns arranged at an edge of the first codeword matrix.

In an implementation form of the third aspect, the method comprises determining a second frozen set of bits in the input matrix, wherein the frozen set of bits and the second frozen set of bits do not overlap; and determine the exclusion set of bits in the first codeword matrix according to the position of the second frozen set of bits in the input matrix.

In an implementation form of the third aspect, the second frozen set of bits is arranged in at least one of a row and a column, which are respectively arranged adjacent to the frozen set of bits in the input matrix; or the second frozen set of bits is arranged in at least one of a row and a column, which are arranged at respective edges of the input matrix.

The method of the third aspect and its implementation forms provide the same advantages as the device of the first aspect and its respective implementation forms.

A fourth aspect of this disclosure provides a method for product polar-code decoding, the method comprising: receiving a second codeword matrix; and determining a first codeword matrix based on the second codeword matrix, wherein the first codeword matrix is obtained by adding a determined set of bits to the second codeword matrix; and polar-decoding the first codeword matrix to obtain an input matrix.

The method of the fourth aspect provides the same advantages as the device of the second aspect.

A fifth aspect of this disclosure provides a computer program comprising instructions which, when executed by a computer, cause the computer to perform a method according to the method of the third aspect or the fourth aspect or any of their implementation forms.

A sixth aspect of the present disclosure provides a non-transitory storage medium storing executable program code which, when executed by a processor, causes the method according to the third aspect or the fourth aspect or any of their implementation forms to be performed.

It has to be noted that all devices, elements, units and means described in the present application could be implemented in the software or hardware elements or any kind of combination thereof. All steps which are performed by the various entities described in the present application as well as the functionalities described to be performed by the various entities are intended to mean that the respective entity is adapted to or configured to perform the respective steps and functionalities. Even if, in the following description of specific embodiments, a specific functionality or step to be performed by external entities is not reflected in the description of a specific detailed element of that entity which performs that specific step or functionality, it should be clear for a skilled person that these methods and functionalities can be implemented in respective software or hardware elements, or any kind of combination thereof.

BRIEF DESCRIPTION OF DRAWINGS

The above described aspects and implementation forms will be explained in the following description of specific embodiments in relation to the enclosed drawings, in which

FIG. 1 illustrates conventional polar-code encoding.

FIG. 2 illustrates conventional polar-code encoding with puncturing.

FIG. 3 illustrates conventional polar-code encoding with shortening.

FIG. 4 illustrates conventional product polar-code encoding.

FIG. 5 shows a device for product polar-code encoding according to an embodiment of the invention.

FIG. 6 shows a device for product polar-code decoding according to an embodiment of the invention.

FIG. 7 shows an example of an input matrix and a first codeword matrix for an edge-punctured product polar code.

FIG. 8 shows an example of an input matrix and a first codeword matrix for a corner-punctured product polar code.

FIG. 9 shows an example of an input matrix and a first codeword matrix for a 1D-punctured product polar code.

FIG. 10 shows an example of an input matrix and a first codeword matrix for an edge-shortened product polar code.

FIG. 11 shows an example of an input matrix and a first codeword matrix for a corner-shortened product polar code.

FIG. 12 shows an example of an input matrix and a first codeword matrix for a 1D-shortened product polar code.

FIG. 13 shows an example of an input matrix of a first-row partial-shortened product polar code.

FIG. 14 shows an example of an input matrix of last-row partial-shortened product polar code.

FIG. 15 shows an example of an input matrix and a first codeword matrix of an edge-punctured partial-shortened product polar code.

FIG. 16 shows a method for product polar-code encoding according to an embodiment of the invention.

FIG. 17 shows a method for product polar-code decoding according to an embodiment of the invention.

DETAILED DESCRIPTION OF EMBODIMENTS

Embodiments of the invention, which enable rate-matching for product polar codes, are based on the four conventional techniques for freezing of polar codes shown in the FIGs. 1-4, which are termed conventional polar codes in the following, in order to distinguish them from product polar codes. Some further considerations of these conventional techniques are explained below.

Conventional polar-coding may use four approaches for freezing (determining the frozen set of bits), namely: (C1) freezing to generate redundancy without any intention to change the code length as shown in FIG. 1). (C2) freezing to generate redundancy and in addition to allow for puncturing of the mother polar code, i.e. deleting code bits with unknown bit values as shown in FIG. 2. (C3) freezing to generate redundancy and in addition to allow for shortening of the mother polar code, i.e., deleting code bits with known bit values, usually zero as shown in FIG. 3. (C4) freezing to generate redundancy and in addition to allow for puncturing and shortening of the mother polar code. Of note, (C4), i.e. combining (C2) and (C3), is possible, but was not yet shown to provide technical advantages.

By combining these freezing approaches, and considering certain constraints, the length and the dimension of a product polar code may be changed. In this disclosure, starting from a conventional product polar code, three basic implementations for rate-matching the product polar code are presented. Further, these three implementations may be combined, in order to create a product polar code of any length and dimension.

Notably, in the following description, frozen sets of bits are depicted in a simplified way, namely, in blocks of bits that are frozen at the beginning and at the end of an input vector. In reality, the frozen sets of bits may be designed according to reliability and/or other criteria, and a puncturing pattern and/or shortening pattern may be chosen in other ways as well together with a set of frozen bits. The simple approach is chosen for the sake of a simple exposition of the principles for the product polar code rate-matching proposed in this disclosure.

FIG. 4 shows conventional product polar-coding, which provides the baseline for $(N^2, K^2)$ product polar codes, which are used in embodiments of the invention as starting points for the rate-matching. Row and component codes have the same code length $N$ and code dimension $K$. The frozen bits of the component polar codes are chosen according to (C1) above. This is referred to as encoding for redundancy, as the positions of the frozen bits are only used to generate redundancy in the product polar code. Product polar code encoding can be done by row-encoding followed by column-encoding, or equivalently by column-encoding followed by row-encoding. The resulting mother product polar codeword (the lower right matrix in FIG. 4, also named the "codeword matrix $X$") is completely transmitted (i.e., no code bits are removed in this conventional approach shown in FIG. 4).

The frozen set of bits in the input matrix U leads to the frozen bits available for row-decoding, as shown in the lower left matrix, and for the frozen bits for the column-encoding, as shown in the upper right matrix. In general, the construction may be irregular, i.e., rows may have different frozen bits, and columns may have different frozen bits.

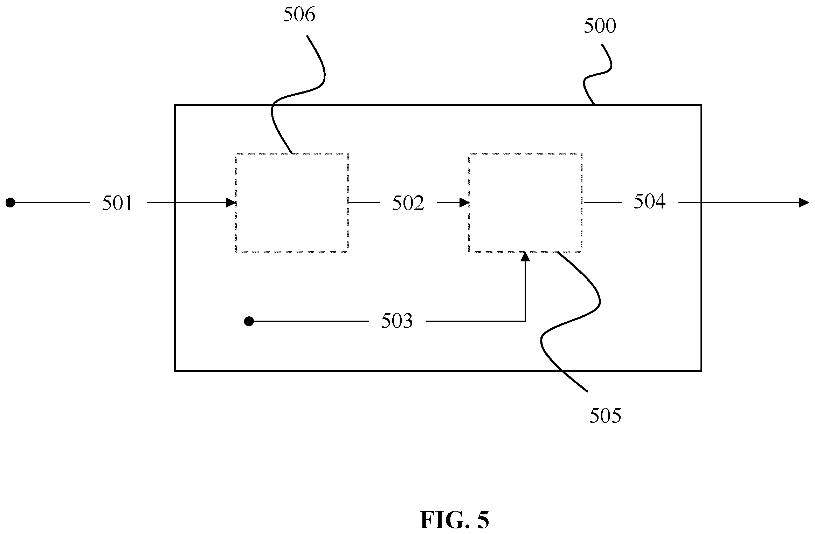

FIG. 5 shows a device 500 for product polar-code encoding according to an embodiment of the invention. The device 500 may be an encoder, or a part of an encoder. The device 500 may be configured to perform product polar-code encoding, based on conventional product polar-code encoding as shown in FIG 4, with an additional puncturing and/or shortening of a codeword matrix, wherein the puncturing and/or shortening is specifically adapted to the product polar code. Thus, the device 500 may be able to perform rate-matching of product polar codes.

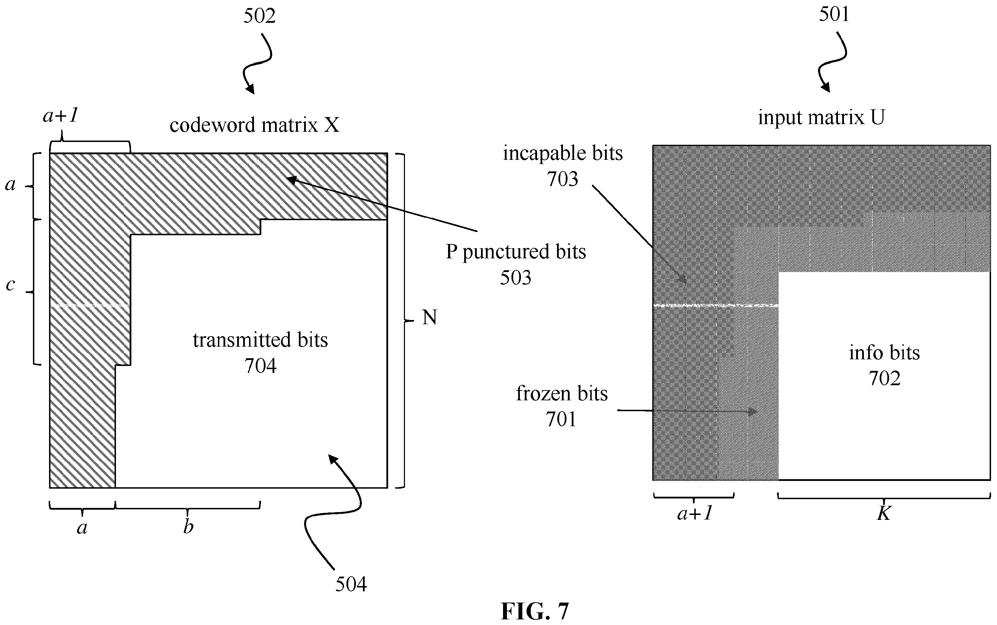

As shown in FIG. 5, the device 500 is configured to obtain an input matrix 501 comprising a frozen set of bits 701 and an information set of bits 702 (see FIG. 7 as an example). The input matrix 501 may be an input matrix as in the conventional case (see FIG. 4). The information set of bits 702 may represent the data to be transmitted.

The device 500 is further configured to polar-encode the input matrix 501 (e.g., by a polar-encoder block 506) to obtain a first codeword matrix 502. The device 500 may be configured to perform this polar-encoding in the conventional case, i.e., like a device that performs the conventional polar-code encoding shown in FIG. 4. In particular, the device 500 may be configured to polar-encode one or more columns of the input matrix 501 to obtain a first matrix, and polar-encode one or more rows of the first matrix to obtain the first codeword matrix 502. Alternatively, the device 500 may be configured to polar-encode one or more rows of the input matrix 501 to obtain a second matrix, and polar-encode one or more columns of the second matrix to obtain the first codeword matrix 502. For the polar-encoding of the columns and rows, respectively, component codes may be used, specifically polar component codes. These component codes may be the result of puncturing or shortening or puncturing-and-shortening an initial polar component code. That is, the resulting polar component codes may comprise less bits than the initial polar component code.

The device 500 is further configured to determine an exclusion set of bits 503 in the first codeword matrix 502. For instance, the device 500 may be configured to determine the exclusion set of bits 503 according to at least one of a puncturing pattern and a shortening pattern, wherein either one of these patterns may be predetermined, pre-configured, or generated by the device 500. The puncturing pattern and/or the shortening pattern may be related to the frozen set of bits 701 in the input matrix 501.

Further, the device 500 is configured to transmit a second codeword matrix 504, wherein the second codeword matrix 504 is obtained by removing the exclusion set of bits 503 from the first codeword matrix 502 (e.g., by a matrix conversion block 505). Accordingly, the bits of the exclusion set 503 are omitted from the first codeword matrix 502 to send the second codeword matrix 504. In particular, the second codeword matrix 504 may be obtained or generated by the device 500, by puncturing and/or shortening the first codeword matrix 502 based on the exclusion set of bits 503, particularly, by removing the exclusion set of bits 503 from the first codeword matrix 502.

Therefore, the second codeword matrix 504 may be a punctured codeword matrix obtained by puncturing the first codeword matrix 503 based on the exclusion set of bits 503, or may be a shortened codeword matrix obtained by shortening the first codeword matrix 502 based on the exclusion set of bits 503. The second codeword matrix 504 may also be a punctured-and-shortened codeword matrix obtained by puncturing and shortening the first codeword matrix 502 based on the exclusion set of bits 503. This will be described in more detail below, with respect to the FIGs. 7-15.

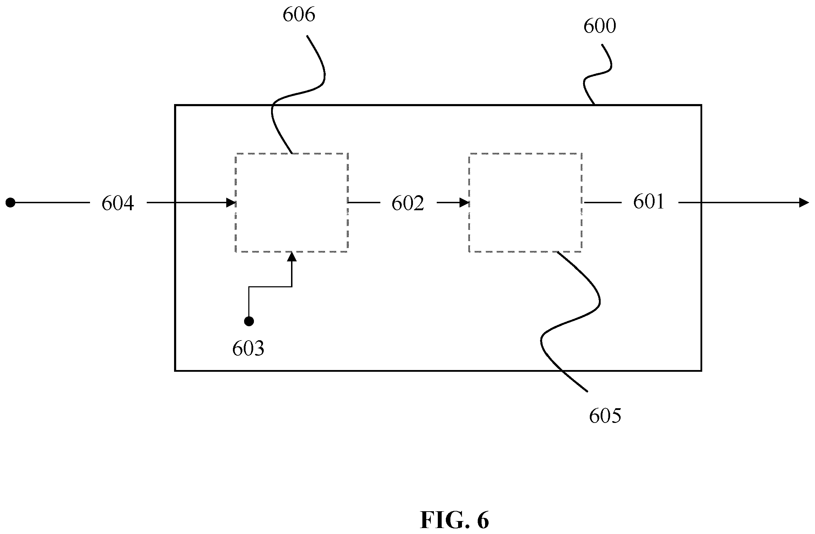

FIG. 6 shows a device 600 for product polar-code decoding according to an embodiment of the invention.

The device 600 is configured to obtain a second codeword matrix 604, for instance, from the device 500. Thereby, the device 500 may send the second codeword matrix 504, as shown in FIG. 5, to the device 600 over a channel, and the device 600 may receive over the channel the second codeword matrix 604. It is possible that the second codeword matrices 504 and 604 are identical.

The device 600 is further configured to determine a first codeword matrix 602 based on the second codeword matrix 604. The first codeword matrix 602 may be obtained by adding a determined set of bits 603 or a determined set of reals values to the second codeword matrix 604 (e.g., by a matrix conversion block 606). The first codeword matrix 602 may correspond to or be the first codeword matrix 502 shown in FIG. 5. The determined set of bits 603 may be determined based on, or may correspond to, the exclusion set of bits 503. The device 500 may provide an indication regarding the exclusion set of bits 503 to the device 600. It is also possible that both the device 500 and 600 have knowledge of the puncturing pattern and/or the shortening pattern. For instance, these may be predetermined or preconfigured at the devices 500 and 600.

Further, the device 600 is configured to polar-decode the first codeword matrix 602 to obtain an input matrix 601 (e.g., by a polar-decoder block 605). The input matrix 601 is ideally identical to the input matrix 501 that is shown in FIG. 5. The device 600 may, in particular, polar-decode one or more columns of the first codeword matrix 602 to obtain a third matrix, and polar-decode one or more rows of the third matrix to obtain the input matrix 601. Alternatively, the device may polar-decode one or more rows of the first codeword matrix 602 to obtain a fourth matrix, and polar-encode one or more columns of the fourth matrix to obtain the input matrix 601. Thereby, hard messages or soft messages may be exchanged between a column-decoder and a row-decoder of the device 600, in particular, after each alternation of column-decoding and row-decoding.

The device 500 and/or the device 600 may comprise a processor or processing circuitry (not shown) configured to perform, conduct or initiate the various operations of the device 500 and/or the device 600 described herein. The processing circuitry may comprise hardware and/or the processing circuitry may be controlled by software. The hardware may comprise analog circuitry or digital circuitry, or both analog and digital circuitry. The digital circuitry may comprise components such as application-specific integrated circuits (ASICs), field-programmable arrays (FPGAs), digital signal processors (DSPs), or multi-purpose processors.

The device 500 and/or the device 600 may further comprise memory circuitry, which stores one or more instruction(s) that can be executed by the processor or by the processing circuitry, in particular under control of the software. For instance, the memory circuitry may comprise a non-transitory storage medium storing executable software code which, when executed by the processor or the processing circuitry, causes the various operations of device 500 and/or the device 600 to be performed.

In one embodiment, the processing circuitry comprises one or more processors and a non-transitory memory connected to the one or more processors. The non-transitory memory may carry executable program code which, when executed by the one or more processors, causes the device 500 and/or the device 600 to perform, conduct or initiate the operations or methods described herein. The processing circuitry may, for instance, comprise the blocks 505 and 506 for the device 500, and respectively 605 and 606 for the device 600.

FIG. 7-9 show product polar-code encoding with puncturing. In particular, these figures show examples of an input matrix 501 and a first codeword matrix 502, respectively, for a punctured product polar code.

Generally, puncturing $P$ bits of a mother ($N^2$, $K^2$) product polar code (as shown in FIG. 4, for instance) means not transmitting $P$ well defined entries (i.e., the exclusion set of bits 503) of the codeword matrix $X$ (i.e. of the first codeword matrix 502). What is transmitted is the remaining bits (i.e., the transmitted bits 704, which form the second codeword matrix 504). The values of the entries (i.e., the bits of the exclusion set of bits 503) may be unknown at the decoder (e.g., at the device 600), so that their LLRs may be zero. Component polar codes may be designed according to (C2) above. Thereby, it is beneficial to pay attention to a set of incapable bits 703 in the input matrix 501, which may be generated during the row-encoding and column-encoding. In the following, three possible product polar code designs are presented, which allow for puncturing the first codeword matrix 502. Note that the row frozen bits and the column frozen bits may be chosen such that the rows and columns affected by the puncturing fulfil the puncturing constraint (C2). In general, the construction may be irregular, i.e., the rows may have different frozen bits, and the columns may have different frozen bits. To avoid the catastrophic error-rate behaviour, the constraint (C2) should be taken into account in the design of the frozen set of bits 701 and in the design of the puncturing pattern, which is used to puncture the first codeword matrix 502.

FIG. 7 shows an example of an input matrix 501 and a first codeword matrix 502 for an edge-punctured product polar code. In particular, the input matrix 501 is depicted as the input matrix $U$, and the first codeword matrix 502 is depicted as the codeword matrix $X$, the matrices being produced by a proposed edge-puncturing method for product polar codes. The idea is to puncture bits (determined by the exclusion set of bits 503) on the left and upper edges of the first codeword matrix 502, namely, by puncturing starting from the first row and first column.

The input matrix 501 of an ($N^2$ - $P$, $K^2$) product polar code may be generated by defining the same component code for both rows and columns. Each component code may contain either $a$ or $a$ + 1 punctured bits, with $a = \left\lfloor N - \sqrt{N^2 - P} \right\rfloor$. Such an ($N$ - $a$ - 1, $K$) component polar code has a puncturing set $\mathcal{P}$ that can be generated through quasi uniform puncturing (QUP) - see, for example, 'Niu, K. et al., "Beyond turbo codes: Rate-compatible punctured polar codes", IEEE International Conference on Communications (ICC), Budapest, Hungary, June 2013' - or through bit-reversal - see, for example, 'V. Bioglio et al., "Low-Complexity Puncturing and Shortening of Polar Codes", IEEE Wireless Communications and Networking Conference (WCNC), San Francisco, CA, USA, March 2017' - or by any other method. In the following, the QUP method is used based on puncturing the first $a$ + 1 bits of the codeword.

The frozen bits of the component polar code may then be calculated according to the knowledge of the puncturing set 503, such that all the bits in the incapable set of bits C are frozen, as depicted in FIG. 2. The structure of the resulting input matrix $U$ is depicted in FIG. 7. The first codeword matrix $X$ may be calculated as usual via successive row-encoding and column-encoding (as described above), and then the punctured bits corresponding to the exclusion set of bits 503 may be removed before transmission. In practice, the first $a$ rows and columns of the first input matrix 502 may be the ones that are not transmitted. Moreover, the first $a$ + c bits of column $a$ + 1, with

$$c = \left\lceil \frac{P - (2aN - a^2) + 1}{2} \right\rceil$$

may be not transmitted, along with the first $a$ + $b$ bits of row $a$ + 1, with

$$b = \left\lfloor \frac{P - (2aN - a^2) + 1}{2} \right\rfloor.$$

The resulting transmitted bits 704, which are transmitted as the second codeword matrix 505, are depicted in FIG. 7. Generally, the second codeword matrix 504 in this exemplary case is a punctured codeword matrix obtained by edge-puncturing the first codeword matrix 502 based on the exclusion set of bits 503. The exclusion set of bits 503 is in this exemplary case determined according to an edge-puncturing pattern, wherein the exclusion set of bits 503 may be selected from one or more columns and one or more rows of the codeword matrix 502, the columns and rows being arranged adjacently at two adjoining edges of the codeword matrix 502.

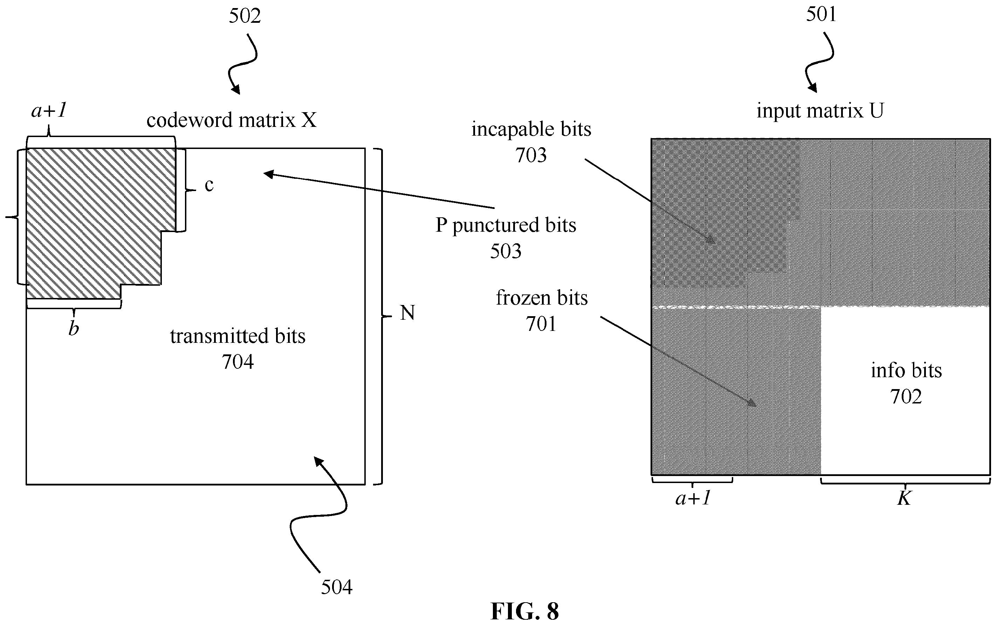

FIG. 8 shows an example of an input matrix 501 and a first codeword matrix 502 for a corner-punctured product polar code. FIG. 8 depicts again the input matrix 501 as the input matrix $U$, and the first codeword matrix 502 as the codeword matrix $X$, which are produced by a proposed corner-puncturing method for product polar codes. The idea is to puncture bits on the left upper corner of the first codeword matrix 502, namely, puncturing only some of the component polar codes. The input matrix 501 of an ($N^2$ - $P$, $K^2$) product polar code may be generated by defining the same component code for both rows and columns. A further constraint may be imposed on the code dimension, namely with $K \leq N - \left\lceil \sqrt{P} \right\rceil$. Each punctured component code may contain either $a$ or $a$ + 1 punctured bits, with $a = \left\lfloor \sqrt{P} \right\rfloor$. Unpunctured component polar codes may be transmitted entirely. However, the component code design may be based on punctured codes, so that punctured and unpunctured codes may share the same frozen bits. Such an ($N$ - $a$ - 1, $K$) component polar code has a puncturing set $\mathcal{P}$ that can be generated through QUP (see e.g. Niu, K. et al), or through bit-reversal (see e.g. V. Bioglio et al.), or by any other method. In the following, the QUP method is used based on puncturing the first a + 1 bits of the codeword.

The frozen bits of the component polar code may then be calculated according to the knowledge of the puncturing set, such that all the bits in the incapable set of bits C (incapable bits 703) may be frozen, as depicted in FIG. 2. The structure of the resulting input matrix U is depicted in FIG. 8. The codeword matrix $X$ may be calculated as usual via successive row-encoding and column-encoding. Then punctured bits corresponding to the exclusions set of bits 503 may be removed before transmission. In practice, the first *a* rows of the first *a* columns may be the ones that are not transmitted. Moreover, the first c bits of column *a* + 1,

$$\text{with } c = \left\lceil \frac{\left[P - \lfloor\sqrt{P}\rfloor\right]^2}{2} \right\rceil,$$

may be not transmitted, along with first *b* bits of row *a* + 1,

$$\text{with } b = \left\lfloor \frac{\left[P - \lfloor\sqrt{P}\rfloor\right]^2}{2} \right\rfloor.$$

The resulting transmitted bits 704, which are transmitted as the second codeword matrix 505, are depicted in FIG. 8. Generally, the second codeword matrix 504 in this exemplary case is a punctured codeword matrix obtained by corner-puncturing the first codeword matrix 502 based on the exclusion set of bits 503. The exclusion set of bits 503 in this exemplary case is determined according to according to a corner-puncturing pattern, wherein the exclusion set of bits 503 is selected from a corner area arranged between two adjoining edges of the codeword matrix 502.

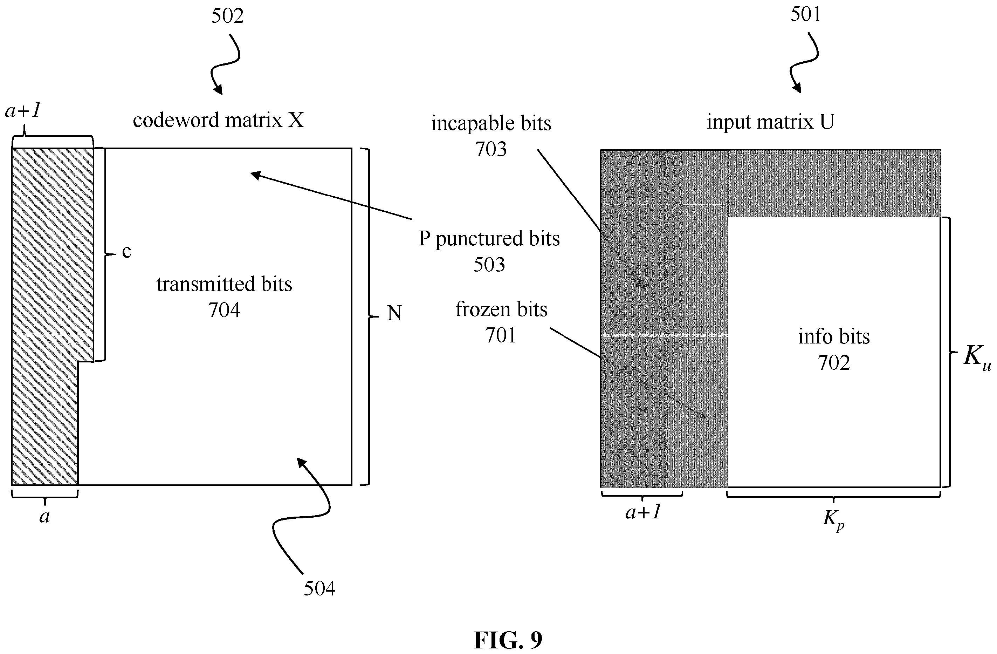

FIG. 9 shows an example of an input matrix 501 and a first codeword matrix 502 for a 1D-punctured (one-dimensional-punctured) product polar code. In particular, FIG. 9 depicts the input matrix 501 as the input matrix U, and the first codeword matrix 502 as the codeword matrix X, which are produced by a proposed 1D-puncturing method for product polar codes. The idea is to puncture bits on one edge of the first codeword matrix 502, e.g. the left or the upper one. The input matrix 501 of an $(N^2 - P, K_p \cdot K_u)$ product polar code may be generated by defining two different component codes, one for the rows and one for the columns. One component code may be punctured, while the other one may be un-punctured. Each punctured component code may contain either *a* or *a* + 1 punctured bits, with $a = \left\lfloor \frac{P}{N} \right\rfloor$. Such an $(N - a - 1, K_p)$ component polar code has a puncturing set $\mathcal{P}$ that can be generated through QUP (see e.g. Niu, K. et al), or through bit-reversal (see e.g. V. Bioglio et al.) or any other method. In the following, the QUP method is used based on puncturing the first *a* + 1 bits of the codeword.

The frozen bits of the punctured component polar code may then be calculated according to the knowledge of the puncturing set (exclusion set 503), such that all the bits in the incapable set of bits C (incapable bits 703) may be frozen, as depicted in FIG. 2. The frozen bits of the un-punctured $(N, K_u)$ component polar code may be calculated according to (C1), as depicted in FIG. 1. The structure of the resulting input matrix U is depicted in FIG. 9. The first codeword matrix X may be calculated as usual via successive row-encoding and column-encoding, and then punctured bits corresponding to o the exclusion set of bits 503 may be removed before transmission. In practice, the first *a* columns may be not transmitted. Moreover, the first c bits of column *a* + 1,

$$\text{with } c = P - \left\lfloor \frac{P}{N} \right\rfloor \cdot N,$$

may be not transmitted.

The resulting transmitted bits 704, which are transmitted as the second codeword matrix 504, are depicted in FIG. 9. The construction may be swapped, puncturing column codes instead of row codes. Generally, the second codeword matrix 504 in this exemplary case is a punctured codeword matrix obtained by 1D-puncturing the first codeword matrix 502 based on the exclusion set of bits 503. The exclusion set of bits 503 in this exemplary case is determined according to a 1D-puncturing pattern, wherein the exclusion set of bits 503 is selected from one or more columns arranged at an edge of the first codeword matrix 502.

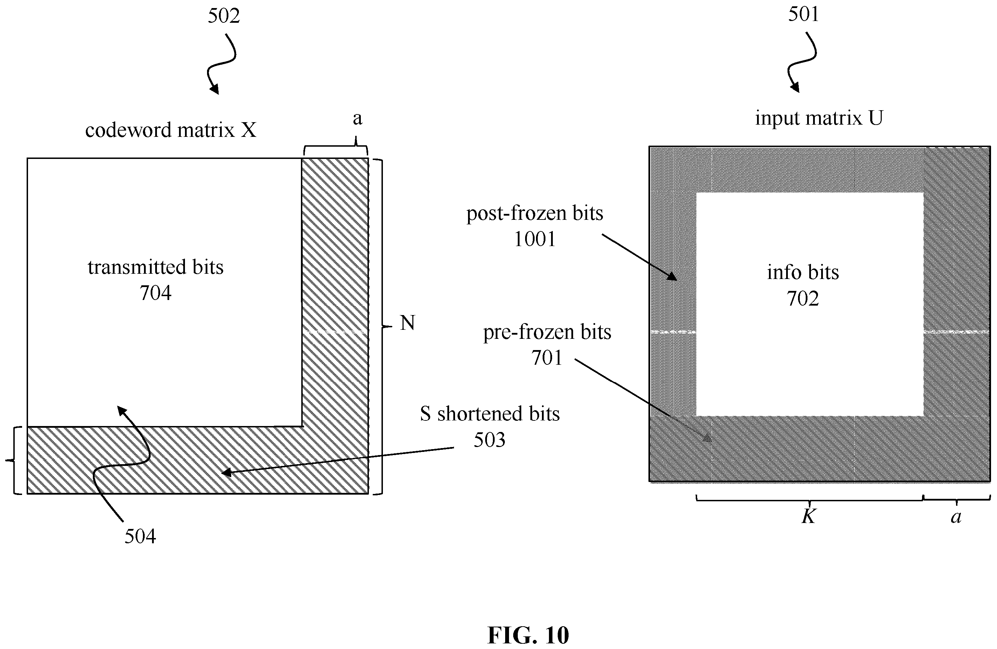

FIG. 10-12 show product polar-code encoding with shortening. In particular, these figures show examples of an input matrix 501 and a first codeword matrix 502 for a shortened product polar code.

In general, shortening S bits of a mother $(N^2, K^2)$ product polar codes means not transmitting S well defined entries (i.e., the exclusion set of bits 503) of a codeword matrix X (i.e., of the first codeword matrix 502.) What is transmitted are the remaining bits (i.e., the transmitted bits 704, which form the second codeword matrix 504). The values of the entries (i.e., the bits of the exclusion set of bits 503) are known at the decoder, so their LLR magnitude may be very high. Component polar codes may be designed according to (C3) above, wherein it is beneficial to pay attention to the position of the shortened bits 503 during the row-decoding and column-decoding. The shortened set (exclusion set of bits 503) may be selected according to certain properties, and the frozen set of bits 701 may contain it. In the following, three possible product polar code designs are provided, which allow for shortening the first codeword matrix 502. Note that the row frozen bits and the column frozen bits may be chosen such that the rows and columns affected by the shortening fulfil the shortening constraint (C3). In general, the construction may be irregular, i.e., the rows may have different frozen bits, and the columns may have different frozen bits. To avoid the catastrophic error-rate behaviour, the constraint (C3) should be taken into account in the design of the frozen sets of bits 701 and the shortening pattern, which is used to shorten the first codeword matrix 502.

FIG. 10 shows an example of an input matrix 501 and a first codeword matrix 502 for an edge-shortened product polar code. In particular, FIG. 10 depicts the input matrix 501 as the input matrix U, and the first codeword matrix 502 as the codeword matrix X, which are produced by a proposed edge-shortening method for product polar codes. The idea is to shorten bits on the right and lower edges of the first codeword matrix 502, namely a shortening starting from the last row and column. The input matrix 501 of an $(N^2 - S, K^2)$ product polar code, with $S = a \cdot (2N - a)$ for some integer $0 < a < N$, may be generated by defining the same component code for both rows and columns. Each component code may contain $a$ shortened bits. Such an $(N - a, K)$ component polar code has a shortening set S that can be generated through block shortening - see, for example, 'R. Wang et al., "A novel puncturing scheme for polar codes", IEEE Communications Letters, vol. 18, no. 12, pp. 2081-2084, December 2014.' - or through bit-reversal (see e.g. V. Bioglio et al.), or by any other method. In the following, the block shortening method is used based on shortening the last $a$ bits of the codeword.

The frozen bits of the component polar code may then be calculated according to the knowledge of the shortening set, such that all the bits in the shortening set S may be frozen as depicted in FIG. 3. The structure of the resulting input matrix U is depicted in FIG. 10. The codeword matrix X may then be calculated as usual via successive row-encoding and column-encoding. Then, shortened bits (the exclusion set of bits 503) may be removed before transmission. In practice, the last $a$ rows and columns may not be transmitted.

The resulting transmitted bits 704, which are transmitted as the second codeword matrix 505, are depicted in FIG. 10. Generally, the second codeword matrix 504 in this exemplary case is a shortened codeword matrix obtained by edge-shortening the first codeword matrix 502 based on the exclusion set of bits 503. The exclusion set of bits 503 in this exemplary case is determined according to an edge-shortening pattern, wherein the exclusion set of bits 503 is selected from a number of one or more columns and from the same number of one or more rows of the first codeword matrix 502, the columns and rows being arranged adjacently at two adjoining edges of the first codeword matrix 502.

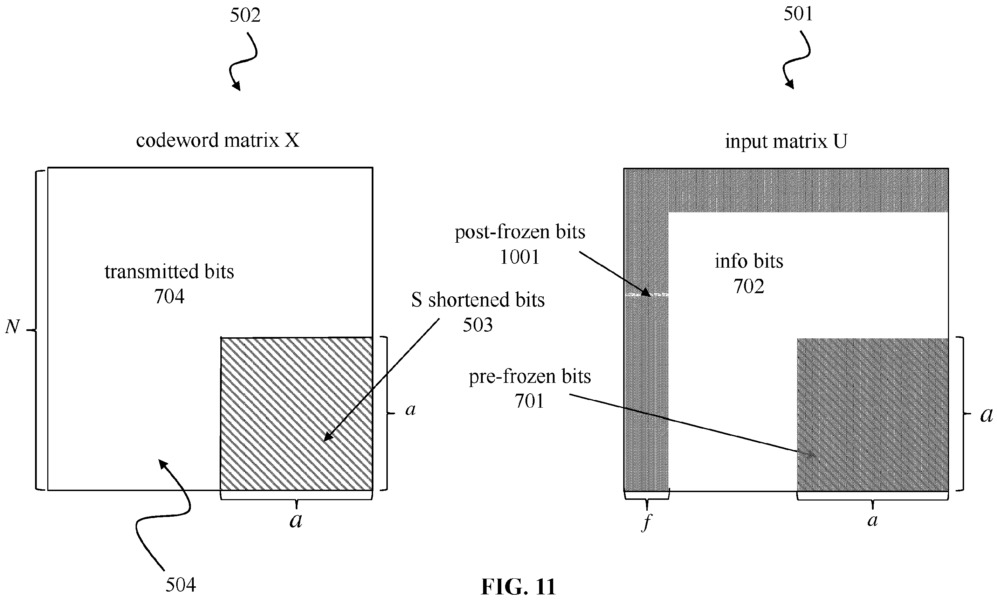

FIG. 11 shows an example of an input matrix 501 and a first codeword matrix 502 for a corner-punctured product polar code. FIG. 11 depicts the input matrix 501 as the input matrix $U$, and the first codeword matrix 502 as the codeword matrix $X$, which are produced by a proposed corner-shortening method for product polar codes. The idea is to shorten bits on the right lower corner of the first codeword matrix 502, namely, shortening only some of the component polar codes. However, the input matrix 501 of an $(N^2 - S, K^2)$ product polar code, with $S = a^2$ for some integer $0 < a < N$, may be generated by defining two component polar codes, one for shortened codes and one for un-shortened codes. These component codes may be used for both rows and columns. A further constraint may be imposed on the code dimension, namely, with $K = (N - f)^2 - a^2$ for some integer $0 < f < N$. Each shortened component code may contain $a$ shortened bits. Un-shortened component polar codes may be transmitted entirely. However, component code design may be based on un-shortened codes, so shortened and un-shortened codes may share part of the frozen set of bits 701. The $(N, K)$ un-shortened component polar code may be generated according to classical polar code design depicted in FIG. 1, having frozen bits F. The $(N - a, N - f - a)$ shortened component polar code has a shortening set S that can be generated through block shortening (see e.g. R. Wang et al.), or through bit-reversal (see e.g. V. Bioglio et al.), or by any other method. In the following, we the block shortening method is based on shortening the last $a$ bits of the code word.

The frozen bits of the shortened component polar code may be given by the union of the un-shortened frozen set of bits F and the shortening set S. The structure of the resulting input matrix $U$ is depicted in FIG. 11. The first codeword matrix $X$ may be calculated as usual via successive row-encoding and column-encoding. Then, shortened bits (the exclusion set of bits 503) may be removed before transmission. In practice, the last $a$ rows of the last $a$ columns may be not transmitted.

The resulting transmitted bits 704, which are transmitted as the second codeword matrix 505, are depicted in FIG. 11. Generally, the second codeword matrix 504 in this exemplary case is a shortened codeword matrix obtained by corner-shortening the first codeword matrix 502 based on the exclusion set of bits 503. The exclusion set of bits 503 in this exemplary case is determined according to a corner-shortening pattern, wherein the exclusion set of bits 503 is selected from a square of entries arranged in a corner area between two adjoining edges of the first codeword matrix 502.

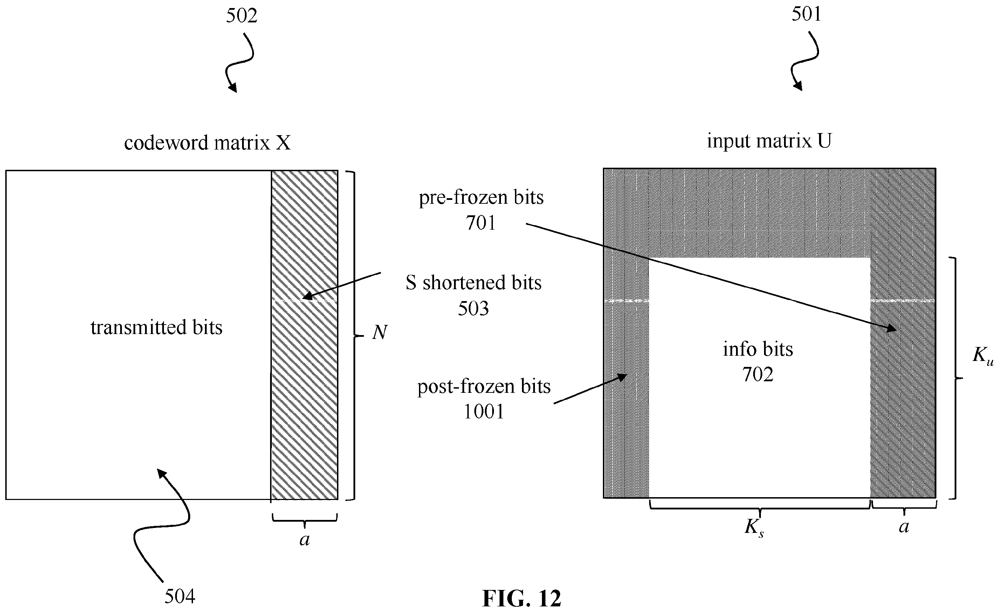

FIG. 12 shows an example of an input matrix 501 and a first codeword matrix 502 for a 1D-shortened (one-dimensional-shortened) product polar code. In particular, FIG. 12 depicts the input matrix 501 as the input matrix U and the first codeword matrix 502 as the codeword matrix X, which is produced by a proposed 1D-shortening method for product polar codes. The idea is to shorten bits on one edge of the first codeword matrix 502, e.g. the right or the lower one. The input matrix 501 of an $(N^2 - S, K_s \cdot K_u)$ product polar code, with $S = aN$ for some integer $0 < a < N$, may be generated by defining two different component codes, one for rows and one for columns; one component code will be shortened, while the other one will be un-shortened. Each shortened component code may contain $a$ shortened bits. Such an $(N - a, K_s)$ component polar code has a puncturing set S that can be generated through block shortening (see e.g. R. Wang et al.), or through bit-reversal (see e.g. V. Bioglio et al.), or by any other method. In the following, the block shortening method is used based on shortening the last $a$ bits of the code word.

The frozen bits of the shortened component polar code may then be calculated according to the knowledge of the shortening set S, such that all the bits in the shortening set S may be frozen as depicted in FIG. 3. The frozen bits of the un-shortened $(N, K_u)$ component polar code may be calculated according to (C1), as depicted in FIG. 1. The structure of the resulting input matrix U is depicted in FIG. 12. The codeword matrix X

may be calculated as usual via successive row-encoding and column-encoding. Then the shortened bits (exclusion set of bits 503) may be removed before transmission. In practice, the first *a* columns may not be transmitted.

The resulting transmitted bits 704, which are transmitted as the second codeword matrix 505, are depicted in FIG. 12. Generally, the second codeword matrix 504 in this exemplary case is a shortened codeword matrix obtained by 1D-shortening the first codeword matrix 502 based on the exclusion set of bits 503. The exclusion set of bits 503 in this exemplary case is determined according to a 1D-shortening pattern, wherein the exclusion set of bits 503 is selected from one or more columns arranged at an edge of the first codeword matrix 502. The construction may be swapped, shortening column codes instead of row codes.

In addition to the above, partial-shortening of a product polar code permits changing the dimension of the product polar code, without affecting its length, namely allowing for dimensions $K$ that are not powers of integers. In practice, this permits generating an ($N^2$, $K$) product polar code from a mother ($N^2$, ($a$ + 1)$^2$) product polar code, where $a = \lfloor \sqrt{K} \rfloor$. In the following, two possible product polar code designs are presented, which allow for partial-shortening. Note that the row frozen bits and the column frozen bits are beneficially chosen such that the rows and columns affected by the shortening fulfil the shortening constraint (C3). In general, the construction may be irregular, i.e., rows may have different frozen bits, and columns may have different frozen bits. To avoid the catastrophic error-rate behaviour, the constraint (C3) may be taken into account in the design of the frozen set of bits 701 and the shortening pattern used to shorten the first codeword matrix 502.

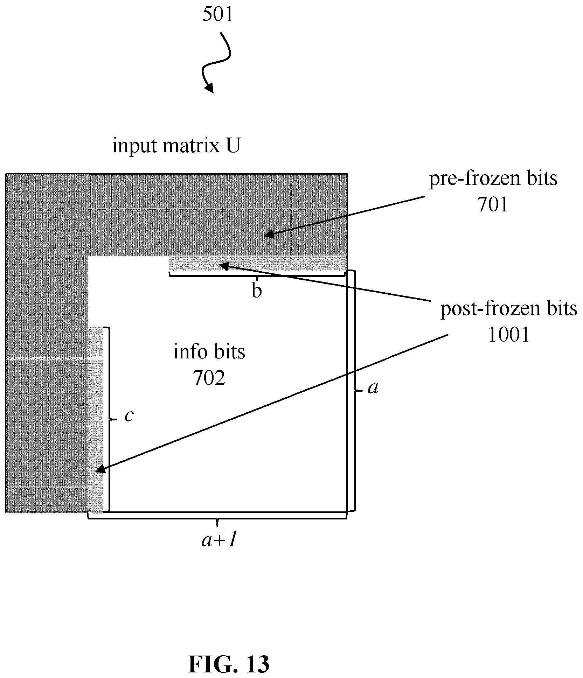

FIG. 13 shows an example of an input matrix 501 of a first-row partial-shortened product polar code. In particular, FIG. 13 depicts the input matrix 501 as the input matrix U, which is produced by a proposed first-row partial-shortening method for product polar codes. The idea is to shorten the last bits of the first row and column code that are not completely frozen. The input matrix 501 of an ($N^2$, $K$) product polar codes may be generated by freezing one extra bit for some of the component row and column codes, thus determining a second set of frozen bits 1001. Each component polar code has frozen bits in the set of $N$ - $a$ - 1 elements, calculated according to (C1). The last

$$c = \left\lceil \frac{K - \lfloor \sqrt{K} \rfloor^2}{2} \right\rceil$$

row codes and the last

$$b = \left\lfloor \frac{K - \lfloor \sqrt{K} \rfloor^2}{2} \right\rfloor$$

column codes may have further frozen bits defining the second frozen set of bits 1001, which may be chosen following the same rule as the previous frozen set of bits 701. The structure of the resulting input matrix U is depicted in FIG. 13. Notably, the frozen set of bits 701 and the second frozen set of bits 1001 may be selected in this exemplary case such that they do not overlap. Furthermore, the exclusion set of bits 503 in the first codeword matrix 502 may be determined according to the position of the second frozen set of bits 1001 in the input matrix 502. The second frozen set of bits 1001 may be arranged in at least one of a row and a column, which are respectively arranged adjacent to the frozen set of bits 701 in the input matrix (as shown in FIG. 13). The codeword matrix X may be calculated as usual via successive row-encoding and column-encoding and then transmitted entirely.

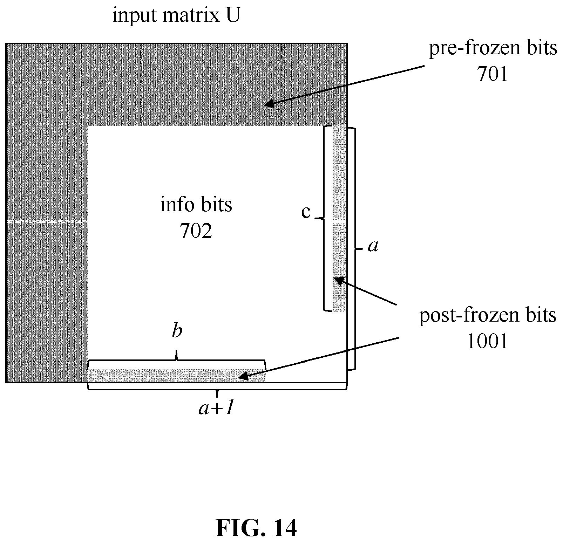

FIG. 14 shows an example on an input matrix 501 of last-row partial-shortened product polar code. In particular, FIG. 14 depicts the input matrix 501 as the input matrix U, which is produced by the proposed last-row partial-shortening method for product polar codes. The idea is to shorten the first bits of the last row and column code that are not completely frozen. The input matrix 501 of an ($N^2$, $K$) product polar codes may be generated by freezing one extra bit for some of the component row and column codes. Each component polar code may have frozen bits in a set of $N$ - $a$ - 1 elements, which may be calculated according to (C1). The last column code may freeze

$$c = \left\lceil \frac{K - \lfloor \sqrt{K} \rfloor^2}{2} \right\rceil$$

extra bits (i.e. bits of a second set of frozen bits 1001 may be determined), while the last row code freezes

$$b = \left\lfloor \frac{K - \lfloor \sqrt{K} \rfloor^2}{2} \right\rfloor$$

extra bits (also bits of the second set of frozen bits 1001). In both cases they may be chosen following the same rule as the previous frozen set of bits 701. The second frozen set of bits 1001 may be arranged in at least one of a row and a column, which are arranged at respective edges of the input matrix 501 (as shown in FIG. 14). The structure of the resulting input matrix U is depicted in FIG. 14. The codeword matrix X may be calculated as usual via successive row-encoding and column-encoding and then transmitted entirely.

It is also possible to combine the previous three approaches to generate a product polar code of any length and dimension. The mechanisms and properties are as explained above. As a result of the initial choice of the frozen bits for the rows and columns in the input matrix 501, the frozen bits for the row and column decoders show frozen bits that can be used for enhanced decoding, and the mother product polar code can be punctured or shortened to obtain the code word of shorter length to be transmitted. As before, generalisation to more irregular structures is possible, and the frozen set of bits 701 design requires to respect the constraints (C1), (C2), (C3) within the frozen bits of rows and columns and their interdependencies, as discussed above. In the following we provide a possible example of mixing the previously presented methods to generate a product polar code of any length and dimension.

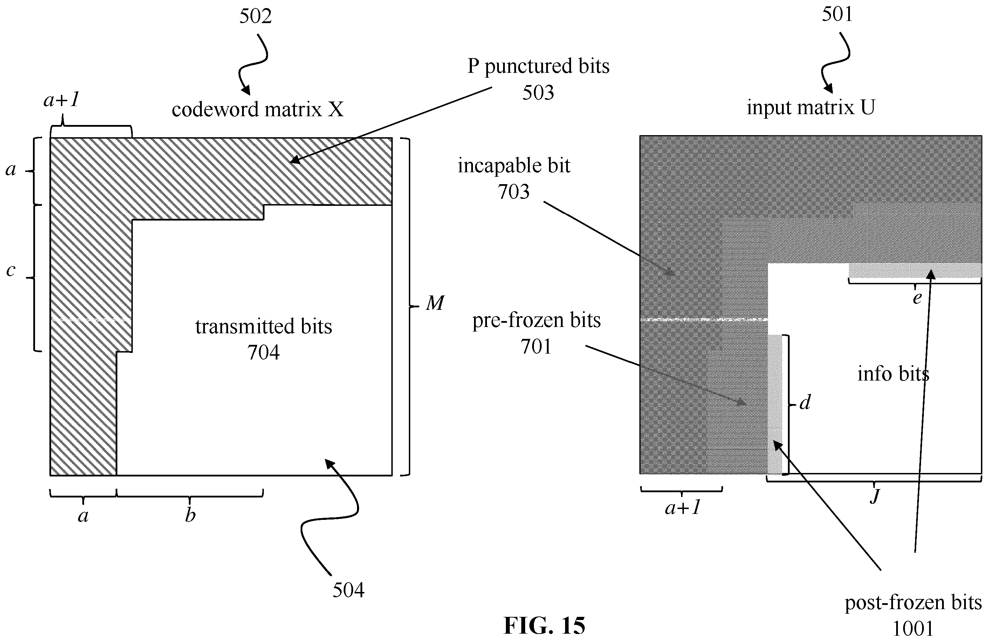

FIG. 15 shows that puncturing and shortening may also be combined. FIG. 15 shows an example of an input matrix 501 and a first codeword matrix 502 of an edge-punctured partial-shortened product polar code. Edge puncturing combined with partial shortening permits to change both the length and the dimension of the product polar code, namely, allowing for dimensions $K$ and lengths $N$ that are not powers of integers. In practice, this permits generating a general $(N, K)$ product polar code from a mother $(M^2, J^2)$ product polar code, where $= \lceil\sqrt{N}\rceil$ and $J = \lceil\sqrt{K}\rceil$. This method may be constructed by mixing edge puncturing and first row partial shortening. To begin with, $P = M^2 - N$ bits are punctured through the edge puncturing. Given $a = \lfloor M - \sqrt{N}\rfloor$, the $(M - a - 1, J)$ component polar code has a puncturing set $\mathcal{P}$ that can be generated through QUP (see K. Niu et al.), or through bit-reversal (see V. Bioglio et al.), or by any other method. In the following, the QUP method is used based on puncturing the first $a + 1$ bits of the code word.

The frozen bits of the component polar code may then be calculated according to the knowledge of the puncturing set (exclusion set of bits 503), such that all the bits in the incapable set of bits C (incapable bits 703) are frozen, as depicted in FIG. 2. Next, the last

$$d = \left\lceil \frac{K - (J - 1)^2}{2} \right\rceil$$

row codes and the last

$$e = \left\lceil \frac{K - (J - 1)^2}{2} \right\rceil$$

column codes may have a second set of frozen bits 1001, which may be chosen following the same rule as the previous set of frozen bits 701. The second frozen set of bits 1001 may arranged in at least one of a row and a column, which are respectively arranged adjacent to the frozen set of bits 701 in the input matrix 501 (as shown in FIG. 15).

The structure of the resulting input matrix $U$ is depicted in FIG. 15. The codeword matrix $X$ may be calculated as usual via successive row-encoding and column-encoding. Then punctured bits (the exclusion set of bits 503) may be removed before transmission. In practice, the first $a$ rows and columns may be not transmitted. Moreover, the first $a + c$ bits of column $a + 1$, with

$$c = \left\lceil \frac{P - (2aM - a^2) + 1}{2} \right\rceil,$$

may not be transmitted, along with first $a + b$ bits of row $a + 1$, with

$$b = \left\lfloor \frac{P - (2aM - a^2) + 1}{2} \right\rfloor.$$

The resulting codeword matrix $X$ is depicted in FIG. 15.

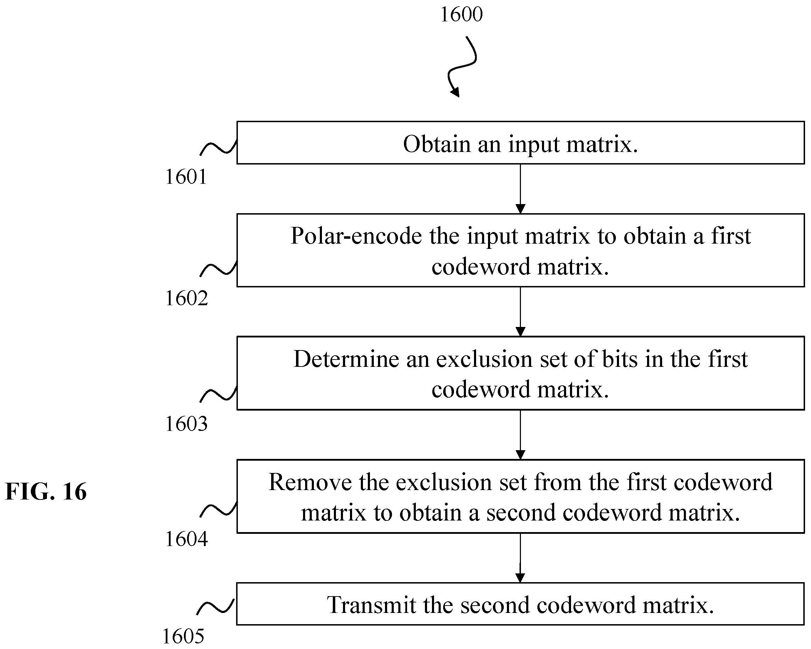

FIG. 16 shows a method 1600 according to an embodiment of the invention. The method 1600 is for product polar-code encoding, and may be performed by the device 500.

The method 1600 comprises a step 1601 of obtaining an input matrix 501 comprising a frozen set of bits 701 and an information set of bits 702. Further, it comprises a step 1602 of polar-encoding the input matrix 501 to obtain a first codeword matrix 502. Then, the method 1600 comprises a step 1603 of determining an exclusion set of bits 503 in the first codeword matrix 502. Further, the method 1600 comprises a step 1604 of removing the exclusion set of bits 503 from the first codeword matrix 502 to obtain a second codeword matrix 504. Finally, the method 1600 comprises a step 1605 of transmitting the second codeword matrix 504.

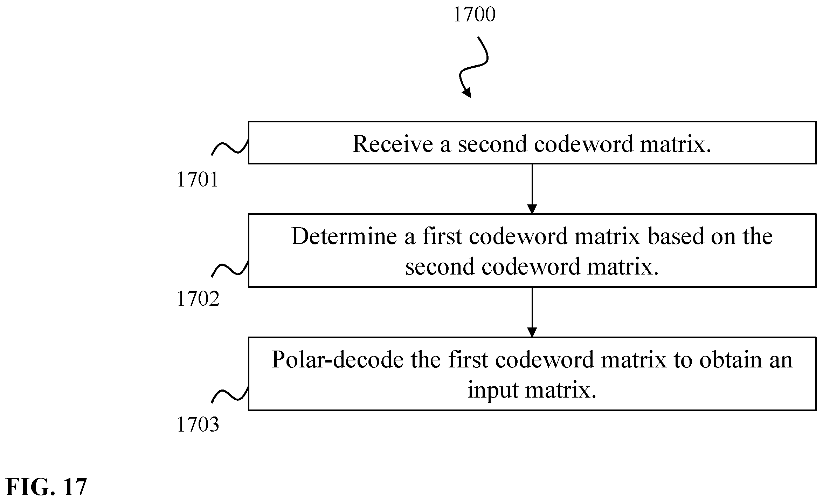

FIG. 17 shows a method 1700 according to an embodiment of the invention. The method 1700 is for product polar-code decoding, and may be performed by the device 600.

The method 1700 comprises a step 1701 of receiving 1701 a second codeword matrix 604. Further, the method 170 comprises a step 1702 of determining a first codeword matrix 602 based on the second codeword matrix 604, wherein the first codeword matrix 602 is obtained by adding a determined set of bits 603 to the second codeword matrix 602. Finally, the method 1700 comprises a step 1703 of polar-decoding the first codeword matrix (602) to obtain an input matrix 601.

In summary, embodiments of the invention provide the advantage of combining the excellent error-rate performance of polar codes with the advantages of iterative product code decoding, including low decoding latency due to parallelizable decoding. Further, embodiments of the invention provide a rate-matching scheme for such product polar codes. In particular, embodiments are provided that allow applying the principles of puncturing and shortening to the product polar codes. Specific constraints for the puncturing and for shortening of the component polar codes are presented, which enable maintaining the good error-rate performance of the product polar codes.

The rate-matching techniques proposed in this disclosure largely extend the potential applications for product polar codes in digital communication systems, in particular where a low decoding delay is required, including wireless communications and optical communications.

The present invention has been described in conjunction with various embodiments as examples as well as implementations. However, other variations can be understood and effected by those persons skilled in the art and practicing the claimed invention, from the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. A device (500) for product polar-code encoding, the device (500) being configured to:

   obtain an input matrix (501) comprising a frozen set of bits (701) and an information set of bits (702), the input matrix (501) having a size $N_c \times N_r$, wherein $N_r$ is a number of columns and $N_c$ is a number of rows;
   polar-encode the input matrix (501) to obtain a first codeword matrix (502);
   determine a second frozen set of bits (1001) in the input matrix (501), wherein the frozen set of bits (701) and the second frozen set of bits (1001) do not overlap;
   determine an exclusion set of bits (503) in the first codeword matrix (502) according to the position of the second frozen set of bits (1001) in the input matrix (502);
   transmit a second codeword matrix (504), wherein the second codeword matrix (504) is obtained by removing the exclusion set of bits (503) from the first codeword matrix (502);
   wherein polar-encoding the input matrix (501) to obtain a first codeword matrix (502) comprises;
   polar-encoding the columns of the input matrix (501) to obtain a first matrix, and polar-encode the rows of the first matrix to obtain the first codeword matrix (502); or
polar-encoding the rows of the input matrix (501) to obtain a second matrix, and polar-encode the columns of the second matrix to obtain the first codeword matrix (502);
wherein the frozen set of bits (701) in the input matrix (501) is constructed in an irregular manner; and
wherein the device (500) is configured to:

   determine the exclusion set of bits (503) according to an edge-puncturing pattern, wherein the exclusion set of bits (503) is selected from one or more columns and one or more rows of the first codeword matrix (502), the columns and rows being arranged adjacently at two adjoining edges of the first codeword matrix (502), wherein at least one of the columns has a length equal to the column length of the first codeword matrix (502) and at least one of the rows has a length equal to the row length of the first codeword matrix (502), wherein punctured bits corresponding to the exclusions set of bits (503) comprise: first $a$ rows and columns of the first input matrix (502), first $a + c$ bits of column $a + 1$ of the first input matrix (502), with $c = \left\lceil \frac{P-(2aN-a^2)+1}{2} \right\rceil$, and first $a + b$ bits of row $a + 1$ of the first input matrix (502), with $b = \left\lfloor \frac{P-(2aN-a^2)+1}{2} \right\rfloor$, wherein $a = \left\lceil N - \sqrt{N^2 - P} \right\rceil$, and P is a number of puncturing bits of a mother ($N^2, K^2$) product polar code ; or
   determine the exclusion set of bits (503) according to a corner-puncturing pattern, wherein the exclusion set of bits (503) is selected from a corner area arranged between two adjoining edges of the first codeword matrix (502), and wherein punctured bits corresponding to the exclusions set of bits (503) comprise: first $a$ rows of first $a$ columns of the of the first input matrix (502), first c bits of column $a + 1$ of the first input matrix (502), with $c = \left\lceil \frac{P-\lfloor\sqrt{P}\rfloor^2}{2} \right\rceil$, and first $b$ bits of row $a + 1$ of the first input matrix (502), with $b = \left\lfloor \frac{P-\lfloor\sqrt{P}\rfloor^2}{2} \right\rfloor$, and with $a = \lfloor \sqrt{P} \rfloor$ ; or
   determine the exclusion set of bits (503) according to a one-dimensional puncturing pattern, wherein the exclusion set of bits

(503) is selected from one or more columns arranged at an edge of the first codeword matrix (502), wherein at least one of the columns has a length equal to the column length of the first codeword matrix (502), wherein punctured bits corresponding to the exclusions set of bits (503) comprise: first $a$ columns of the first input matrix (502), and first c bits of column $a + 1$ of the first input matrix (502), with $c = P - \left\lfloor \frac{P}{N} \right\rfloor \cdot N$, and with $a = \left\lfloor \frac{P}{N} \right\rfloor$; or determine the exclusion set of bits (503) according to an edge-puncturing combined with partial-shortening pattern, wherein the exclusion set of bits (503) comprises: first $a$ rows and columns of the first input matrix (502), first $a + c$ bits of column $a + 1$ of the first input matrix (502), with $c = \left\lceil \frac{P - (2aM - a^2) + 1}{2} \right\rceil$, and first $a + b$ bits of row $a + 1$ of the first input matrix (502), with $b = \left\lfloor \frac{P - (2aM - a^2) + 1}{2} \right\rfloor$, and with $a = \left\lfloor M - \sqrt{N} \right\rfloor$ for a (N, K) product polar code generated from a mother $(M^2, J^2)$ product polar code.

2. The device (500) according to claim 1, wherein:

the second codeword matrix (504) is a punctured codeword matrix obtained by puncturing the first codeword matrix (502) based on the exclusion set of bits (503), or
the second codeword matrix (504) is a shortened codeword matrix obtained by shortening the first codeword matrix (502) based on the exclusion set of bits (503), or
the second codeword matrix (504) is a punctured-and-shortened codeword matrix obtained by puncturing and shortening the first codeword matrix (502) based on the exclusion set of bits (503).

3. The device (500) according to claim 1, configured to:
generate the second codeword matrix (504) by puncturing and/or shortening the first codeword matrix (502) based on the exclusion set of bits (503).

4. The device (500) according to one of the claims 1 to 3, configured to:

determine the exclusion set of bits (503) in the first codeword matrix (502) to be a predetermined puncturing and/or shortening pattern;
wherein the puncturing and/or shortening pattern is related to the frozen set of bits (701) in the input matrix (501).

5. The device (500) according to claim 4, configured to:
generate the input matrix (501), wherein the frozen set of bits (701) in the input matrix (501) is based on the predetermined puncturing and/or shortening pattern.

6. The device (500) according to one of the claims 1 to 5, wherein:

the frozen set of bits (701) in the input matrix (501) comprises a sub-set of bits (703); and
the exclusion set of bits (503) in the first codeword matrix (502) is determined based on the sub-set of bits (703) of the frozen set of bits (701) in the input matrix (501).

7. The device (500) according to claim 1, configured to:

polar-encode the one or more columns of the input matrix (501), or the one or more columns of the second matrix, based on a first component code; and
polar-encode the one or more rows of the first matrix, or the one or more rows of the input matrix (501), based on a second component code;
wherein one component code of the first component code and the second component code is a punctured and/or shortened component code, which comprises less bits than the other component code.

8. A method (1600) for product polar-code encoding, the method (1600) comprising:

obtaining (1601) an input matrix (501) comprising a frozen set of bits (701) and an information set of bits (702), the input matrix (501) having a size $N_c \times N_r$, wherein $N_r$ is a number of columns and $N_c$ is a number of rows;
polar-encoding (1602) the input matrix (501) to obtain a first codeword matrix (502);
determining a second frozen set of bits (1001) in the input matrix (501), wherein the frozen set of bits (701) and the second frozen set of bits (1001) do not overlap;
determining (1603) an exclusion set of bits (503) in the first codeword matrix (502) according to the position of the second frozen set of bits (1001) in the input matrix (502); and
transmitting (1605) a second codeword matrix (504), wherein the second codeword matrix (504) is obtained by removing (1603) the exclusion set of bits (503) from the first codeword matrix (502);

wherein polar-encoding the input matrix (501) to obtain a first codeword matrix (502) comprises; polar-encoding the columns of the input matrix (501) to obtain a first matrix, and polar-encode the rows of the first matrix to obtain the first codeword matrix (502); or polar-encoding the rows of the input matrix (501) to obtain a second matrix, and polar-encode the columns of the second matrix to obtain the first codeword matrix (502);

wherein the frozen set of bits (701) in the input matrix (501) is constructed in an irregular manner; and

wherein the method (1600) further comprises:

determining the exclusion set of bits (503) according to an edge-puncturing pattern, wherein the exclusion set of bits (503) is selected from one or more columns and one or more rows of the first codeword matrix (502), the columns and rows being arranged adjacently at two adjoining edges of the first codeword matrix (502), wherein at least one of the columns has a length equal to the column length of the first codeword matrix (502) and at least one of the rows has a length equal to the row length of the first codeword matrix (502), wherein punctured bits corresponding to the exclusions set of bits (503) comprise: first $a$ rows and columns of the first input matrix (502), first $a$ + c bits of column $a$ + 1 of the first input matrix (502), with $c = \left\lceil \frac{P-(2aN-a^2)+1}{2} \right\rceil$,

and first $a$ + $b$ bits of row $a$ + 1 of the first input matrix (502), with $b = \left\lfloor \frac{P-(2aN-a^2)+1}{2} \right\rfloor$, wherein

$a = \left\lfloor N - \sqrt{N^2 - P} \right\rfloor$, and $P$ is a number of puncturing bits of a mother ($N^2$, $K^2$) product polar code ; or

determining the exclusion set of bits (503) according to a corner-puncturing pattern, wherein the exclusion set of bits (503) is selected from a corner area arranged between two adjoining edges of the first codeword matrix (502), and wherein punctured bits corresponding to the exclusions set of bits (503) comprise: first $a$ rows of first $a$ columns of the of the first input matrix (502), first c bits of column $a$ + 1 of the first input matrix (502), with $c = \left\lceil \frac{P-\lfloor\sqrt{P}\rfloor^2}{2} \right\rceil$, and first $b$ bits of row $a$ + 1 of the first input matrix (502), with $b = \left\lfloor \frac{P-\lfloor\sqrt{P}\rfloor^2}{2} \right\rfloor$, and with

$a = \left\lfloor \sqrt{P} \right\rfloor$ ; or

determining the exclusion set of bits (503) according to a one-dimensional puncturing pattern, wherein the exclusion set of bits (503) is selected from one or more columns arranged at an edge of the first codeword matrix (502), wherein at least one of the columns has a length equal to the column length of the first codeword matrix (502), wherein punctured bits corresponding to the exclusions set of bits (503) comprise: first $a$ columns of the first input matrix (502), and first c bits of column $a$ + 1 of the first input matrix (502), with $c = P - \left\lfloor \frac{P}{N} \right\rfloor \cdot N$,

and with $a = \left\lfloor \frac{P}{N} \right\rfloor$ ; or

determining the exclusion set of bits (503) according to an edge-puncturing combined with partial-shortening pattern, wherein the exclusion set of bits (503) comprises: first $a$ rows and columns of the first input matrix (502), first $a$ + c bits of column $a$ + 1 of the first input matrix (502), with $c = \left\lceil \frac{P-(2aM-a^2)+1}{2} \right\rceil$, and first $a$ + $b$ bits of row $a$ + 1 of the first input matrix (502), with $b = \left\lfloor \frac{P-(2aM-a^2)+1}{2} \right\rfloor$, and with $a = \left\lfloor M - \sqrt{N} \right\rfloor$ for a (N, K) product polar code generated from a mother ($M^2$, $J^2$) product polar code.

9. A computer program comprising instructions which, when executed by a computer, cause the computer to perform a method according to claim 8.

**Patentansprüche**

1. Vorrichtung (500) zum Produktpolarcodecodieren, wobei die Vorrichtung (500) konfiguriert ist zum:

Erhalten einer Eingabematrix (501), die einen eingefrorenen Satz von Bits (701) und einen Informationssatz von Bits (702) umfasst, wobei die Eingabematrix (501) eine Größe $N_c$ x $N_r$ aufweist, wobei $N_r$ eine Anzahl von Spalten ist und $N_c$ eine Anzahl von Zeilen ist; Polarcodieren der Eingabematrix (501), um eine erste Codewortmatrix (502) zu erhalten; Bestimmen eines zweiten eingefrorenen Satzes von Bits (1001) in der Eingabematrix (501), wobei sich der eingefrorene Satz von Bits (701) und der zweite eingefrorene Satz von Bits (1001) nicht überlappen;

Bestimmen eines Ausschlusssatzes von Bits (503) in der ersten Codewortmatrix (502) gemäß der Position des zweiten eingefrorenen Satzes von Bits (1001) in der Eingabematrix (502);

Senden einer zweiten Codewortmatrix (504), wobei die zweite Codewortmatrix (504) durch ein Entfernen des Ausschlusssatzes von Bits (503) aus der ersten Codewortmatrix (502) erhalten wird;

wobei das Polarcodieren der Eingabematrix (501), um eine erste Codewortmatrix (502) zu erhalten, umfasst;

Polarcodieren der Spalten der Eingabematrix (501), um eine erste Matrix zu erhalten, und Polarcodieren der Zeilen der ersten Matrix, um die erste Codewortmatrix (502) zu erhalten; oder

Polarcodieren der Zeilen der Eingabematrix (501), um eine zweite Matrix zu erhalten, und Polarcodieren der Spalten der zweiten Matrix, um die erste Codewortmatrix (502) zu erhalten;

wobei der eingefrorene Satz von Bits (701) in der Eingabematrix (501) in einer unregelmäßigen Weise konstruiert ist; und

wobei die Vorrichtung (500) konfiguriert ist zum:

Bestimmen des Ausschlusssatzes von Bits (503) gemäß einem Kantenpunktierungsmuster, wobei der Ausschlusssatz von Bits (503) aus einer oder mehreren Spalten und einer oder mehreren Zeilen der ersten Codewortmatrix (502) ausgewählt ist, wobei die Spalten und Zeilen benachbart an zwei angrenzenden Kanten der ersten Codewortmatrix (502) angeordnet sind, wobei mindestens eine der Spalten eine Länge gleich der Spaltenlänge der ersten Codewortmatrix (502) aufweist und mindestens eine der Zeilen eine Länge gleich der Zeilenlänge der ersten Codewortmatrix (502) aufweist, wobei punktierte Bits, die dem Ausschlusssatz von Bits (503) entsprechen, umfassen: erste a Zeilen und Spalten der ersten Eingabematrix (502), erste a + c Bits von Spalte a + 1 der ersten Eingabematrix (502), mit $c = \left\lceil \frac{P - (2aN - a^2) + 1}{2} \right\rceil$, und erste a + b Bits von Zeile a + 1 der ersten Eingabematrix (502), mit $b = \left\lfloor \frac{P - (2aN - a^2) + 1}{2} \right\rfloor$, wobei $a = \left\lfloor N - \sqrt{N^2 - P} \right\rfloor$, und P eine Anzahl von Punktiersbits eines Mutter-($N^2$, $K^2$)-Produktpolarcodes ist; oder

Bestimmen des Ausschlusssatzes von Bits (503) gemäß einem Eckpunktierungsmuster, wobei der Ausschlusssatz von Bits (503) aus einem Eckbereich, der zwischen zwei angrenzenden Kanten der ersten Codewortmatrix (502) angeordnet ist, ausgewählt ist und wobei punktierte Bits, die dem Ausschlusssatz von Bits (503) entsprechen, umfassen: erste a Zeilen von ersten a Spalten der der ersten Eingabematrix (502), erste c Bits von Spalte a + 1 der ersten Eingabematrix (502), mit $c = \left\lceil \frac{P - \lfloor\sqrt{P}\rfloor^2}{2} \right\rceil$, und erste b Bits von Zeile a + 1 der ersten Eingabematrix (502), mit $b = \left\lfloor \frac{P - \lfloor\sqrt{P}\rfloor^2}{2} \right\rfloor$, und mit $a = \lfloor \sqrt{P} \rfloor$; oder

Bestimmen des Ausschlusssatzes von Bits (503) gemäß einem eindimensionalen Punktierungsmuster, wobei der Ausschlusssatz von Bits (503) aus einer oder mehreren Spalten, die an einer Kante der ersten Codewortmatrix (502) angeordnet sind, ausgewählt ist, wobei mindestens eine der Spalten eine Länge gleich der Spaltenlänge der ersten Codewortmatrix (502) aufweist, wobei punktierte Bits, die dem Ausschlusssatz von Bits (503) entsprechen, umfassen: erste a Spalten der ersten Eingabematrix (502) und erste c Bits von Spalte a + 1 der ersten Eingabematrix (502), mit $c = P - \left\lfloor \frac{P}{N} \right\rfloor \cdot N$ und mit $a = \left\lfloor \frac{P}{N} \right\rfloor$; oder

Bestimmen des Ausschlusssatzes von Bits (503) gemäß einem Kantenpunktierungskombiniert mit einem Teilverkürzungsmuster, wobei der Ausschlusssatz von Bits (503) umfasst: erste a Zeilen und Spalten der ersten Eingabematrix (502), erste a + c Bits von Spalte a + 1 der ersten Eingabematrix (502), mit $c = \left\lceil \frac{P - (2aM - a^2) + 1}{2} \right\rceil$, und erste a + b Bits von Zeile a + 1 der ersten Eingabematrix (502), mit $b = \left\lfloor \frac{P - (2aM - a^2) + 1}{2} \right\rfloor$, und mit $a = \left\lfloor M - \sqrt{N} \right\rfloor$ für einen (N, K)-Produktpolarcode, der aus einem Mutter-($M^2$, $J^2$)-Produktpolarcode erzeugt wird.

**2.** Vorrichtung (500) nach Anspruch 1, wobei:

die zweite Codewortmatrix (504) eine punktierte Codewortmatrix, die durch das Punktieren der ersten Codewortmatrix (502) basierend auf dem Ausschlusssatz von Bits (503) erhalten wird, ist oder

die zweite Codewortmatrix (504) eine verkürzte Codewortmatrix, die durch das Verkürzen der ersten Codewortmatrix (502) basierend auf dem Ausschlusssatz von Bits (503) erhalten wird, ist oder

die zweite Codewortmatrix (504) eine punktierte und verkürzte Codewortmatrix, die durch das Punktieren und das Verkürzen der ersten Codewortmatrix (502) basierend auf dem Ausschlusssatz von Bits (503) erhalten wird, ist.

3. Vorrichtung (500) nach Anspruch 1, die konfiguriert ist zum:
Erzeugen der zweiten Codewortmatrix (504) durch das Punktieren und/oder das Verkürzen der ersten Codewortmatrix (502) basierend auf dem Ausschlusssatz von Bits (503).

4. Vorrichtung (500) nach einem der Ansprüche 1 bis 3, die konfiguriert ist zum:

Bestimmen des Ausschlusssatzes von Bits (503) in der ersten Codewortmatrix (502) als ein vorbestimmtes Punktierungs- und/oder Verkürzungsmuster;
wobei das Punktierungs- und/oder Verkürzungsmuster sich auf den eingefrorenen Satz von Bits (701) in der Eingabematrix (501) bezieht.

5. Vorrichtung (500) nach Anspruch 4, die konfiguriert zum:
Erzeugen der Eingabematrix (501), wobei der eingefrorene Satz von Bits (701) in der Eingabematrix (501) auf dem vorbestimmten Punktierungs- und/oder Verkürzungsmuster basiert.

6. Vorrichtung (500) nach einem der Ansprüche 1 bis 5, wobei:

der eingefrorene Satz von Bits (701) in der Eingabematrix (501) einen Teilsatz von Bits (703) umfasst; und
der Ausschlusssatz von Bits (503) in der ersten Codewortmatrix (502) basierend auf dem Teilsatz von Bits (703) des eingefrorenen Satzes von Bits (701) in der Eingabematrix (501) bestimmt wird.

7. Vorrichtung (500) nach Anspruch 1, die konfiguriert ist zum:

Polarcodieren der einen oder der mehreren Spalten der Eingabematrix (501) oder der einen oder der mehreren Spalten der zweiten Matrix, basierend auf einem ersten Komponentencode; und

Polarcodieren der einen oder der mehreren Zeilen der ersten Matrix oder der einen oder der mehreren Zeilen der Eingabematrix (501), basierend auf einem zweiten Komponentencode;
wobei ein Komponentencode des ersten Komponentencodes und des zweiten Komponentencodes ein punktierter und/oder verkürzter Komponentencode, der weniger Bits als der andere Komponentencode umfasst, ist.

8. Verfahren (1600) zum Produktpolarcodecodieren, wobei das Verfahren (1600) umfasst:

Erhalten (1601) einer Eingabematrix (501), die einen eingefrorenen Satz von Bits (701) und einen Informationssatz von Bits (702) umfasst, wobei die Eingabematrix (501) eine Größe $N_c$ x $N_r$ aufweist, wobei $N_r$ eine Anzahl von Spalten ist und $N_c$ eine Anzahl von Zeilen ist;
Polarcodieren (1602) der Eingabematrix (501), um eine erste Codewortmatrix (502) zu erhalten;
Bestimmen eines zweiten eingefrorenen Satzes von Bits (1001) in der Eingabematrix (501), wobei sich der eingefrorene Satz von Bits (701) und der zweite eingefrorene Satz von Bits (1001) nicht überlappen;
Bestimmen (1603) eines Ausschlusssatzes von Bits (503) in der ersten Codewortmatrix (502) gemäß der Position des zweiten eingefrorenen Satzes von Bits (1001) in der Eingabematrix (502); und
Senden (1605) einer zweiten Codewortmatrix (504), wobei die zweite Codewortmatrix (504) durch ein Entfernen (1603) des Ausschlusssatzes von Bits (503) aus der ersten Codewortmatrix (502) erhalten wird;
wobei das Polarcodieren der Eingabematrix (501), um eine erste Codewortmatrix (502) zu erhalten, umfasst;
Polarcodieren der Spalten der Eingabematrix (501), um eine erste Matrix zu erhalten, und Polarcodieren der Zeilen der ersten Matrix, um die erste Codewortmatrix (502) zu erhalten; oder
Polarcodieren der Zeilen der Eingabematrix (501), um eine zweite Matrix zu erhalten, und Polarcodieren der Spalten der zweiten Matrix, um die erste Codewortmatrix (502) zu erhalten;
wobei der eingefrorene Satz von Bits (701) in der Eingabematrix (501) in einer unregelmäßigen Weise konstruiert ist; und
wobei das Verfahren (1600) ferner umfasst:

Bestimmen des Ausschlusssatzes von Bits

(503) gemäß einem Kantenpunktierungsmuster, wobei der Ausschlusssatz von Bits (503) aus einer oder mehreren Spalten und einer oder mehreren Zeilen der ersten Codewortmatrix (502) ausgewählt ist, wobei die Spalten und Zeilen benachbart an zwei angrenzenden Kanten der ersten Codewortmatrix (502) angeordnet sind, wobei mindestens eine der Spalten eine Länge gleich der Spaltenlänge der ersten Codewortmatrix (502) aufweist und mindestens eine der Zeilen eine Länge gleich der Zeilenlänge der ersten Codewortmatrix (502) aufweist, wobei punktierte Bits, die dem Ausschlusssatz von Bits (503) entsprechen, umfassen: erste a Zeilen und Spalten der ersten Eingabematrix (502), erste a + c Bits von Spalte a + 1 der ersten Eingabematrix (502), mit $c = \left\lceil \frac{P-(2aN-a^2)+1}{2} \right\rceil$ , und erste a + b Bits von Zeile a + 1 der ersten Eingabematrix (502), mit

$$b = \left\lfloor \frac{P-(2aN-a^2)+1}{2} \right\rfloor , \text{ wobei}$$

$$a = \left\lfloor N - \sqrt{N^2 - P} \right\rfloor , \text{ und P ei-}$$

ne Anzahl von Punktierungsbits eines Mutter-($N^2$, $K^2$)-Produktpolarcodes ist; oder Bestimmen des Ausschlusssatzes von Bits (503) gemäß einem Eckpunktierungsmuster, wobei der Ausschlusssatz von Bits (503) aus einem Eckbereich, der zwischen zwei angrenzenden Kanten der ersten Codewortmatrix (502) angeordnet ist, ausgewählt ist und wobei punktierte Bits, die dem Ausschlusssatz von Bits (503) entsprechen, umfassen: erste a Zeilen von ersten a Spalten der der ersten Eingabematrix (502), erste c Bits von Spalte a + 1 der ersten Eingabematrix (502), mit $c = \left\lceil \frac{P-\lfloor\sqrt{P}\rfloor^2}{2} \right\rceil$ , und erste b Bits von Zeile a + 1 der ersten Eingabematrix (502), mit

$$b = \left\lfloor \frac{P-\lfloor\sqrt{P}\rfloor^2}{2} \right\rfloor , \text{ und mit } a = \left\lfloor \sqrt{P} \right\rfloor ; \text{oder}$$

Bestimmen des Ausschlusssatzes von Bits (503) gemäß einem eindimensionalen Punktierungsmuster, wobei der Ausschlusssatz von Bits (503) aus einer oder mehreren Spalten, die an einer Kante der ersten Codewortmatrix (502) angeordnet sind, ausgewählt ist, wobei mindestens eine der Spalten eine Länge gleich der Spaltenlänge der ersten Codewortmatrix (502) aufweist, wobei punktierte Bits, die dem Ausschlusssatz von Bits (503) entsprechen, umfassen: erste a Spalten der ersten Eingabematrix (502) und erste c Bits von Spalte a + 1 der ersten Eingabematrix (502), mit $c = P - \left\lceil \frac{P}{N} \right\rceil \cdot N$, und mit

$$a = \left\lceil \frac{P}{N} \right\rceil ; \text{oder}$$

Bestimmen des Ausschlusssatzes von Bits (503) gemäß einem Kantenpunktierungskombiniert mit einem Teilverkürzungsmuster, wobei der Ausschlusssatz von Bits (503) umfasst: erste a Zeilen und Spalten der ersten Eingabematrix (502), erste a + c Bits von Spalte a + 1 der ersten Eingabematrix (502), mit

$$c = \left\lceil \frac{P-(2aM-a^2)+1}{2} \right\rceil , \text{ und erste a +}$$

b Bits von Zeile a + 1 der ersten Eingabematrix (502), mit $b = \left\lfloor \frac{P-(2aM-a^2)+1}{2} \right\rfloor$ ,

und mit $a = \left\lfloor M - \sqrt{N} \right\rfloor$ für einen (N, K)-Produktpolarcode, der aus einem Mutter-($M^2$, $J^2$)-Produktpolarcode erzeugt wird.

9. Computerprogramm, das Anweisungen umfasst, die, wenn sie durch einen Computer ausgeführt werden, den Computer veranlassen, ein Verfahren nach Anspruch 8 durchzuführen.

**Revendications**

1. Dispositif (500) pour le codage de code polaire de produit, le dispositif (500) étant configuré pour :

obtenir une matrice d'entrée (501) comprenant un ensemble gelé de bits (701) et un ensemble d'informations de bits (702), la matrice d'entrée (501) présentant une taille $N_c \times N_r$ dans lequel $N_r$ est un nombre de colonnes et $N_c$ est un nombre de lignes ;
coder de manière polaire la matrice d'entrée (501) pour obtenir une première matrice de mot code (502) ;
déterminer un second ensemble gelé de bits (1001) dans la matrice d'entrée (501), dans lequel l'ensemble gelé de bits (701) et le second ensemble gelé de bits (1001) ne se chevauchent pas ;
déterminer un ensemble d'exclusion de bits (503) dans la première matrice de mot code (502) selon la position du second ensemble gelé de bits (1001) dans la matrice d'entrée (502) ;
transmettre une seconde matrice de mot code (504), dans lequel la seconde matrice de mot code (504) est obtenue en retirant l'ensemble d'exclusion de bits (503) de la première matrice de mot code (502) ;

dans lequel le codage polaire de la matrice d'entrée (501) pour obtenir une première matrice de mot code (502) comprend ;

le codage polaire des colonnes de la matrice d'entrée (501) pour obtenir une première matrice, et le codage polaire des lignes de la première matrice pour obtenir la première matrice de mot code (502) ; ou

le codage polaire des lignes de la matrice d'entrée (501) pour obtenir une seconde matrice, et le codage polaire des colonnes de la seconde matrice pour obtenir la première matrice de mot code (502) ;

dans lequel l'ensemble gelé de bits (701) dans la matrice d'entrée (501) est construit d'une manière irrégulière ; et

dans lequel le dispositif (500) est configuré pour :

déterminer l'ensemble d'exclusion de bits (503) selon un motif de perforation de bord, dans lequel l'ensemble d'exclusion de bits (503) est choisi parmi une ou plusieurs colonnes et une ou plusieurs lignes de la première matrice de mot code (502), les colonnes et les lignes étant agencées de manière adjacente au niveau de deux bords contigus de la première matrice de mot code (502), dans lequel au moins une des colonnes présente une longueur égale à la longueur de colonne de la première matrice de mot code (502) et au moins l'une des lignes présente une longueur égale à la longueur de ligne de la première matrice de mot code (502), dans lequel des bits perforés correspondant à l'ensemble d'exclusions de bits (503) comprennent :

a premières lignes et colonnes de la première matrice d'entrée (502), a + c premiers bits de la colonne a + 1 de la première matrice d'entrée (502), avec

$$c = \left\lceil \frac{P-(2aN-a^2)+1}{2} \right\rceil$$, et a + b premiers bits de la ligne a + 1 de la première matrice d'entrée (502), avec

$$b = \left\lfloor \frac{P-(2aN-a^2)+1}{2} \right\rfloor$$, dans lequel $$a = \left\lfloor N - \sqrt{N^2 - P} \right\rfloor$$, et P est un nombre de bits de perforation d'un code polaire de produit mère ($N^2$, $K^2$) ; ou

déterminer l'ensemble d'exclusion de bits (503) selon un motif de perforation d'angle, dans lequel l'ensemble d'exclusion de bits (503) est choisi dans une zone d'angle agencée entre deux bords contigus de la première matrice de mot code (502), et dans lequel des bits perforés correspondant à l'ensemble d'exclusions de bits (503) comprennent : a premières lignes des premières colonnes de la de la première matrice d'entrée (502), c premiers bits de la colonne a + 1 de la première matrice d'entrée (502), avec

$$c = \left\lceil \frac{P-\lfloor\sqrt{P}\rfloor^2}{2} \right\rceil$$, et b premiers bits de la ligne a + 1 de la première matrice d'entrée (502), avec $$b = \left\lfloor \frac{P-\lfloor\sqrt{P}\rfloor^2}{2} \right\rfloor$$,

et avec $$a = \left\lfloor \sqrt{P} \right\rfloor$$ ;

déterminer l'ensemble d'exclusion de bits (503) selon un motif de perforation unidimensionnel, dans lequel l'ensemble d'exclusion de bits (503) est choisi parmi une ou plusieurs colonnes agencées au niveau d'un bord de la première matrice de mot code (502), dans lequel au moins l'une des colonnes présente une longueur égale à la longueur de colonne de la première matrice de mot code (502), dans lequel des bits perforés correspondant à l'ensemble d'exclusions de bits (503) comprennent : a premières colonnes de la première matrice d'entrée (502), et c premiers bits de la colonne a + 1 de la première matrice d'entrée (502), avec $$c = P - \left\lfloor \frac{P}{N} \right\rfloor \cdot N$$ et avec

$$a = \left\lfloor \frac{P}{N} \right\rfloor$$ ; ou

déterminer l'ensemble d'exclusion de bits (503) selon une perforation de bord combinée à un modèle de raccourcissement partiel, dans lequel l'ensemble d'exclusion de bits (503) comprend : a premières lignes et colonnes de la première matrice d'entrée (502), a + c premiers bits de la colonne a + 1 de la première matrice d'entrée (502),

avec $$c = \left\lceil \frac{P-(2aM-a^2)+1}{2} \right\rceil$$, et a

+ *b* premiers bits de la ligne *a* + 1 de la première matrice d'entrée (502), avec

$$b = \left\lfloor \frac{P - (2aM - a^2) + 1}{2} \right\rfloor \text{ , et avec}$$

$$a = \left\lfloor M - \sqrt{N} \right\rfloor \text{ pour un code polaire de produit } (N, K) \text{ généré à partir d'un code polaire de produit mère } (M^2, J^2).$$

2. Dispositif (500) selon la revendication 1, dans lequel :

la seconde matrice de mot code (504) est une matrice de mot code perforée obtenue par perforation de la première matrice de mot code (502) sur la base de l'ensemble d'exclusion de bits (503), ou
la seconde matrice de mot code (504) est une matrice de mot code raccourcie obtenue par raccourcissement de la première matrice de mot code (502) sur la base de l'ensemble d'exclusion de bits (503), ou
la seconde matrice de mot code (504) est une matrice de mot code perforée et raccourcie obtenue par perforation et raccourcissement de la première matrice de mot code (502) sur la base de l'ensemble d'exclusion de bits (503).

3. Dispositif (500) selon la revendication 1, configuré pour :
générer la seconde matrice de mot code (504) par perforation et/ou raccourcissement de la première matrice de mot code (502) sur la base de l'ensemble d'exclusion de bits (503).

4. Dispositif (500) selon l'une des revendications 1 à 3, configuré pour :

déterminer l'ensemble d'exclusion de bits (503) dans la première matrice de mot code (502) comme étant un modèle de perforation et/ou de raccourcissement prédéterminé ;
dans lequel le motif de perforation et/ou de raccourcissement est lié à l'ensemble gelé de bits (701) dans la matrice d'entrée (501).

5. Dispositif (500) selon la revendication 4, configuré pour :
générer la matrice d'entrée (501), dans lequel l'ensemble gelé de bits (701) dans la matrice d'entrée (501) est basé sur le motif de perforation et/ou de raccourcissement prédéterminé.

6. Dispositif (500) selon l'une des revendications 1 à 5, dans lequel :

l'ensemble gelé de bits (701) dans la matrice d'entrée (501) comprend un sous-ensemble de bits (703) ; et
l'ensemble d'exclusion de bits (503) dans la première matrice de mot code (502) est déterminé sur la base du sous-ensemble de bits (703) de l'ensemble gelé de bits (701) dans la matrice d'entrée (501).

7. Dispositif (500) selon la revendication 1, configuré pour :

coder de manière polaire la ou les colonnes de la matrice d'entrée (501), ou la ou les colonnes de la seconde matrice, sur la base d'un premier code de composant ; et coder de manière polaire la ou les lignes de la première matrice, ou la ou les lignes de la matrice d'entrée (501), sur la base d'un second code de composant ;
dans lequel un code de composant du premier code de composant et du second code de composant est un code de composant perforé et/ou raccourci, qui comprend moins de bits que l'autre code de composant.

8. Procédé (1600) pour un codage de code polaire de produit, le procédé (1600) comprenant :

l'obtention (1601) d'une matrice d'entrée (501) comprenant un ensemble gelé de bits (701) et un ensemble d'informations de bits (702), la matrice d'entrée (501) présentant une taille $N_c$ x $N_r$ dans lequel $N_r$ est un nombre de colonnes et $N_c$ est un nombre de lignes ;
le codage polaire (1602) de la matrice d'entrée (501) pour obtenir une première matrice de mot code (502) ;
la détermination d'un second ensemble gelé de bits (1001) dans la matrice d'entrée (501), dans lequel l'ensemble gelé de bits (701) et le second ensemble gelé de bits (1001) ne se chevauchent pas ;
la détermination (1603) d'un ensemble d'exclusion de bits (503) dans la première matrice de mot code (502) selon la position du second ensemble gelé de bits (1001) dans la matrice d'entrée (502) ; et
la transmission (1605) d'une seconde matrice de mot code (504), dans lequel la seconde matrice de mot code (504) est obtenue par retrait (1603) de l'ensemble d'exclusion de bits (503) de la première matrice de mot code (502) ;
dans lequel le codage polaire de la matrice d'entrée (501) pour obtenir une première matrice de mot code (502) comprend ;

le codage polaire des colonnes de la matrice d'entrée (501) pour obtenir une première matrice, et le codage polaire des lignes de la première matrice pour obtenir la première matrice de mot code (502) ; ou le codage polaire des lignes de la matrice d'entrée (501) pour obtenir une seconde matrice, et le codage polaire des colonnes de la seconde matrice pour obtenir la première matrice de mot code (502) ; dans lequel l'ensemble gelé de bits (701) dans la matrice d'entrée (501) est construit d'une manière irrégulière ; et dans lequel le procédé (1600) comprend en outre :

la détermination de l'ensemble d'exclusion de bits (503) selon un motif de perforation de bord, dans lequel l'ensemble d'exclusion de bits (503) est choisi parmi une ou plusieurs colonnes et une ou plusieurs lignes de la première matrice de mot code (502), les colonnes et les lignes étant agencées de manière adjacente au niveau de deux bords contigus de la première matrice de mot code (502), dans lequel au moins l'une des colonnes présente une longueur égale à la longueur de colonne de la première matrice de mot code (502) et au moins une des lignes présente une longueur égale à la longueur de ligne de la première matrice de mot code (502), dans lequel des bits perforés correspondant à l'ensemble d'exclusion de bits (503) comprennent :

a premières lignes et colonnes de la première matrice d'entrée (502), a + c premiers bits de la colonne a + 1 de la première matrice d'entrée (502), avec $c = \left\lceil \frac{P-(2aN-a^2)+1}{2} \right\rceil$, et a + b premiers bits de la ligne a + 1 de la première matrice d'entrée (502), avec

$$b = \left\lfloor \frac{P-(2aN-a^2)+1}{2} \right\rfloor ,$$

dans lequel

$$a = \left\lfloor N - \sqrt{N^2 - P} \right\rfloor ,$$

et $P$ est un nombre de bits de perforation d'un code polaire de produit mère ($N^2, K^2$) ; ou la détermination de l'ensemble d'exclusion de bits (503) selon un motif de perforation d'angle, dans lequel l'ensemble d'exclusion de bits (503) est choisi dans une zone d'angle agencée entre deux bords contigus de la première matrice de mot code (502), et dans lequel des bits perforés correspondant à l'ensemble d'exclusion de bits (503) comprennent : a premières lignes de a premières colonnes de la première matrice d'entrée (502), c premiers bits de la colonne a + 1 de la première matrice d'entrée (502), avec $c = \left\lceil \frac{\left\lceil P - \lfloor\sqrt{P}\rfloor \right\rceil^2}{2} \right\rceil$ , et b premiers bits de la ligne a + 1 de la première matrice d'entrée (502), avec $b = \left\lfloor \frac{\left\lceil P - \lfloor\sqrt{P}\rfloor \right\rceil^2}{2} \right\rfloor$ , et

avec $a = \left\lfloor \sqrt{P} \right\rfloor$ ; ou la détermination de l'ensemble d'exclusion de bits (503) selon un motif de perforation unidimensionnel, dans lequel l'ensemble d'exclusion de bits (503) est choisi parmi une ou plusieurs colonnes agencées au niveau d'un bord de la première matrice de mot code (502), dans lequel au moins une des colonnes présente une longueur égale à la longueur de colonne de la première matrice de mot code (502), dans lequel des bits perforés correspondant à l'ensemble d'exclusion de bits (503) comprennent : a premières colonnes de la première matrice d'entrée (502), et c premiers bits de la colonne a + 1 de la première matrice d'entrée (502), avec $c = P - \left\lfloor \frac{P}{N} \right\rfloor \cdot N$ , et avec $a = \left\lfloor \frac{P}{N} \right\rfloor$ ; ou la détermination de l'ensemble d'exclusion de bits (503) selon une perforation de bord combinée à un motif de raccourcissement partiel, dans lequel l'ensemble d'exclusion de bits (503) comprend : a premières lignes et colonnes de la première matrice d'entrée (502), a + c premiers bits de la colonne a + 1 de la première matrice d'entrée (502), avec

$$c = \left\lceil \frac{P-(2aM-a^2)+1}{2} \right\rceil$$ , et *a* +

*b* premiers bits de la ligne a + 1 de la première matrice d'entrée (502), avec $$b = \left\lfloor \frac{P-(2aM-a^2)+1}{2} \right\rfloor$$ , et

avec $a = \left\lfloor M - \sqrt{N} \right\rfloor$ pour un code polaire de produit (*N, K*) généré à partir d'un code polaire de produit mère ($M^2$, $J^2$).

9. Programme informatique comprenant des instructions qui, lorsqu'elles sont exécutées par un ordinateur, amènent l'ordinateur à réaliser un procédé selon la revendication 8.

input vector u

Polar transform. Matrix T

Codeword x=uT

| 0000 | |

frozen set F  info set I

keep all code bits

transmitted codeword

**FIG. 1**

FIG. 2

input vector u frozen set F

info set I

shortening pattern S

mother codeword

remove known code bits

shortened codeword

**FIG. 3**

input matrix U

frozen set

info set

a1: row encoder

b1: column encoder

a2: column encoder

b2: row encoder

product polar codeword X

transmitted product polar codeword

**FIG. 4**

EP 4 205 283 B1

EP 4 205 283 B1

**FIG. 5**

EP 4 205 283 B1

**FIG. 6**

FIG. 7

502

*a+1*

codeword matrix X

c

incapable bits
703

P punctured bits
503

*b*

frozen bits
701

transmitted bits
704

N

504

501

input matrix U

info bits
702

*a+1*

*K*

**FIG. 8**

$a+1$

codeword matrix X

502

$a$

c

transmitted bits
704

N

504

incapable bits
703

P punctured bits
503

frozen bits
701

input matrix U

501

info bits
702

$K_u$

$a+1$

$K_p$

**FIG. 9**

codeword matrix X

a

transmitted bits
704

N

S shortened bits
503

504

502

input matrix U

501

post-frozen bits
1001

info bits
702

pre-frozen bits
701

K        a

EP 4 205 283 B1

**FIG. 10**

FIG. 11

**codeword matrix X**

transmitted bits

S shortened bits
503

$N$

$a$

504

**input matrix U**

pre-frozen bits
701

info bits
702

post-frozen bits
1001

$K_u$

$K_s$

$a$

**FIG. 12**

EP 4 205 283 B1

501

input matrix U

pre-frozen bits
701

b

post-frozen bits
1001

info bits
702

c

a

a+1

**FIG. 13**

input matrix U

pre-frozen bits
701

info bits
702

c

a

post-frozen bits
1001

b

a+1

**FIG. 14**

**FIG. 15**

1600

Obtain an input matrix.

Polar-encode the input matrix to obtain a first codeword matrix.

Determine an exclusion set of bits in the first codeword matrix.

**FIG. 16**

Remove the exclusion set from the first codeword matrix to obtain a second codeword matrix.

Transmit the second codeword matrix.

1700

Receive a second codeword matrix.

1701

Determine a first codeword matrix based on the second codeword matrix.

1702

Polar-decode the first codeword matrix to obtain an input matrix.

1703

**FIG. 17**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1317070 A1

**Non-patent literature cited in the description**

- **HANIF MOHAMMAD ABU et al.** A Novel Scheme of Product Polar Codes with High Efficiency and Rate Compatibility. *WIRELESS COMMUNICATIONS AND MOBILE COMPUTING*, vol. 2020, 1-13
- EXIT Convergence Analysis of BICM-ID Based on High-Dimensional Modulation and Polar-TPC. **KOIKE-AKINO TOSHIAKI et al.** PROC. IEEE EUROPEAN CONFERENCE ON OPTICAL COMMUNICATION (ECOC). IEEE, 2018, 1-3
- **CONDO, CARLO et al.** Practical Product Code Construction of Polar Codes. *IEEE TRANSACTIONS ON SIGNAL PROCESSING, IEEE SERVICE CENTER*, vol. 68, 2004-2014
- Construction and Decoding of Product Codes with Non-Systematic Polar Codes. **BIOGLIO VALERIO et al.** PROC. IEEE WIRELESS COMMUNICATIONS AND NETWORKING CONFERENCE (WCNC). IEEE, 2019, 1-6
- Near Optimal Decoding of Polar-based Turbo Product Codes. **RUAN MENG et al.** PROC. 11TH INTERNATIONAL CONFERENCE ON WIRELESS COMMUNICATIONS AND SIGNAL PROCESSING (WCSP). IEEE, 2019, 1-5
- Length-Compatible Polar Codes: A Survey. **TONNELLIER THIBAUD et al.** PROC. 53RD ANNUAL CONFERENCE ON INFORMATION SCIENCES AND SYSTEMS (CISS). IEEE, 2019, 1-6
- **ABU HANIF MOHAMMAD et al.** A Modified Approach to Punctured Product Polar Codes. *J. of Telecommunications and Information Technology*, vol. 3 (2019), 63-69
- **ALI ESLAMI et al.** A Practical Approach to Polar Codes. *arXiv:1107.5355v1*
- **SARKIS GABI et al.** Flexible and Low-Complexity Encoding and Decoding of Systematic Polar Codes. *IEEE TRANSACTIONS ON COMMUNICATIONS, IEEE SERVICE*, vol. 64 (7), 2732-2745
- **NIU, K. et al.** Beyond turbo codes: Rate-compatible punctured polar codes. *IEEE International Conference on Communications (ICC)*, June 2013
- Low-Complexity Puncturing and Shortening of Polar Codes. **V. BIOGLIO et al.** IEEE Wireless Communications and Networking Conference (WCNC). March 2017
- **R. WANG et al.** A novel puncturing scheme for polar codes. *IEEE Communications Letters*, December 2014, vol. 18 (12), 2081-2084